# EUROPEAN PATENT APPLICATION

(11) **EP 4 822 917 A1**
(43) Date of publication of application: **14.10.2026**
(21) Application number: 24900002.7
(22) Date of filing: 06.12.2024
(51) Int. Cl.: H01S 5/0233, H01S 5/042, H01S 5/40

(54) **LASER AND LASER DEVICE**

(30) Priority: 08.12.2023 CN 202311683844; 14.08.2024 CN 202411117893
(71) Applicant: Hisense Laser Display Co., Ltd., Huangdao District Qingdao, Shandong 266555 (CN)
(72) Inventor: ZHOU, Zinan, Qingdao, Shandong 266555 (CN); TIAN, Youliang, Qingdao, Shandong 266555 (CN); LI, Wei, Qingdao, Shandong 266555 (CN); YU, Xiaofu, Qingdao, Shandong 266555 (CN); HAN, Xu, Qingdao, Shandong 266555 (CN); DUAN, Chongyao, Qingdao, Shandong 266555 (CN); ZHANG, Xin, Qingdao, Shandong 266555 (CN); LU, Yao, Qingdao, Shandong 266555 (CN); GUO, Mengxiao, Qingdao, Shandong 266555 (CN); GUO, Zhaoshi, Qingdao, Shandong 266555 (CN); LU, Yunchen, Qingdao, Shandong 266555 (CN); ZHANG, Minglong, Qingdao, Shandong 266555 (CN)
(74) Representative: Cabinet Beau de Loménie
(86) International application number: PCT/CN2024/137594
(87) International publication number: WO 2025/119369

(57) **Abstract**

A laser (10) and a laser device. The laser (10) comprises: a mounting substrate (130), comprising a connection pattern, multiple connection pads (132), and multiple in-board connection lines (1301), wherein the multiple connection pads (132) are electrically connected to the connection pattern by means of the multiple in-board connection lines (1301); an light-emitting unit comprises tube housings (110, 120) and light-emitting chips (113) arranged in the tube housings (110, 120); a conductive structure (114) is arranged on the tube housings (110, 120) at the side facing the mounting substrate (130); the connection pattern comprises conductive patterns (1311, 1312); the light-emitting unit is fixed on the conductive patterns (1311, 1312) and is electrically connected to the conductive patterns (1311, 1312); side wall connecting lines (117) are provided in a side wall (140) of the tube housings (110, 120), and the light-emitting chips (113) are electrically connected to the side wall connecting lines (117); the light-emitting chips (113) in the light-emitting unit include at least two types of chips (113) that emit light having different colors; the connection pads (132) include a group of two connection pads (132) respectively corresponding to the light-emitting chips (113) of each color, and each group of connection pads (132) is electrically connected to the light-emitting chip (113) of the corresponding color.

## Description

This application claims priority to Chinese Patent Application No. 202311683844.6, filed on December 8, 2023, entitled "LIGHT EMITTING DEVICE AND LASER APPARATUS", and Chinese Patent Application No. 202411117893.8, filed on August 14, 2024, entitled "LASER DEVICE ASSEMBLY AND PROJECTION APPARATUS", the entire contents of which are incorporated herein by reference.

### TECHNICAL FIELD

The present disclosure relates to the field of optoelectronic technology, and in particular, to a laser device and a laser apparatus.

### BACKGROUND

Currently, the laser projection industry is developing very rapidly, and laser devices, as one of the core components, play an irreplaceable role. Semiconductor laser devices are manufactured by packaging chips after the chips are produced. Therefore, the packaging capability of a laser device has a significant impact on its application, cost, performance, and other aspects. Based on the development of laser devices and the demand for color display, laser device packaging pursues the emission of high-quality light beams, with the expectation that when applied to an optical path, the use of optical path components can be minimized, thereby enabling miniaturization and simplification of laser display devices.

### SUMMARY

Embodiments of the present disclosure provide a laser device and a laser apparatus, the technical solutions of which are as follows.

In one aspect, a laser device is provided, including:
a mounting substrate, including a connection pattern, a plurality of connection pads, and a plurality of intra-board connection lines, wherein at least four of the connection pads are electrically connected to the connection pattern via the plurality of intra-board connection lines; and
a light emitting unit, the light emitting unit including at least one package and a plurality of light emitting chips disposed within the at least one package, wherein the at least one package is provided with a conductive structure on a side thereof facing the mounting substrate, the connection pattern includes a conductive pattern corresponding to the light emitting unit, the light emitting unit is fixed on the corresponding conductive pattern and is electrically connected to the corresponding conductive pattern, at least one sidewall connection line is disposed within a sidewall of the at least one package, and at least one of the light emitting chips is electrically connected to one of the sidewall connection lines within a sidewall of a package that houses the light emitting chip;
wherein the light emitting chips in the light emitting unit include light emitting chips having at least two different emission colors, the plurality of connection pads include a group of connection pads corresponding to each emission color of the light emitting chips in the light emitting unit, each group of connection pads includes two of the connection pads, and each group of connection pads is electrically connected to the light emitting chips of the corresponding color.

In another aspect, a laser apparatus is provided, including any of the above laser devices, a light valve assembly, and a lens.

### BRIEF DESCRIPTION OF DRAWINGS

To describe the technical solutions in the embodiments of the present disclosure more clearly, the following briefly introduces the accompanying drawings required for describing the embodiments. Apparently, the accompanying drawings in the following description are merely some embodiments of the present disclosure, and a person of ordinary skill in the art may still derive other drawings from these accompanying drawings without creative effort.
FIG. 1 is a schematic diagram illustrating an operating principle of a laser device in the related art;
FIG. 2 is a circuit diagram illustrating a common-anode wiring scheme of a laser device in the related art;
FIG. 3 is a circuit diagram illustrating a common-cathode wiring scheme of a laser device in the related art;
FIG. 4 is a schematic diagram illustrating an appearance structure of a laser device according to an embodiment of the present disclosure;
FIG. 5 is a schematic exploded structural diagram of a laser device according to an embodiment of the present disclosure;
FIG. 6 is a schematic side cross-sectional structural diagram of a laser device according to an embodiment of the present disclosure;
FIG. 7 is a schematic diagram illustrating a surface structure of a package of a laser device on a side facing a mounting substrate according to an embodiment of the present disclosure;
FIG. 8 is a schematic top-view structural diagram of a mounting substrate in a laser device according to an embodiment of the present disclosure;
FIG. 9 is a schematic side cross-sectional structural diagram of a package in a laser device according to an embodiment of the present disclosure;
FIG. 10 is a schematic circuit diagram of a laser device according to an embodiment of the present disclosure;
FIG. 11 is a schematic top-view planar structural diagram of a laser device according to an embodiment of the present disclosure;
FIG. 12 is a schematic top-view structural diagram of another laser device according to an embodiment of the present disclosure;
FIG. 13 is a schematic top-view structural diagram of yet another laser device according to an embodiment of the present disclosure;
FIG. 14 is a schematic top-view structural diagram of yet another laser device according to an embodiment of the present disclosure;
FIG. 15 is a schematic diagram illustrating a circuit connection relationship of a package of yet another laser device according to an embodiment of the present disclosure;
FIG. 16 is a schematic diagram illustrating an internal electrical connection relationship of a package of yet another laser device according to an embodiment of the present disclosure;
FIG. 17 is a schematic diagram illustrating an internal structure of a package of yet another laser device according to an embodiment of the present disclosure;
FIG. 18 is a schematic side cross-sectional structural diagram of a package of yet another laser device according to an embodiment of the present disclosure;
FIG. 19 is a schematic diagram illustrating an internal electrical connection relationship of a package of yet another laser device according to an embodiment of the present disclosure;
FIG. 20 is a schematic diagram illustrating an internal structure of a package of yet another laser device according to an embodiment of the present disclosure;
FIG. 21 is a schematic side cross-sectional structural diagram of a package of yet another laser device according to an embodiment of the present disclosure;
FIG. 22 is a schematic structural diagram of a package of yet another laser device according to an embodiment of the present disclosure;
FIG. 23 is a schematic top-view structural diagram of yet another laser device according to an embodiment of the present disclosure;
FIG. 24 is a schematic top-view planar structural diagram of yet another laser device according to an embodiment of the present disclosure;
FIG. 25 is a schematic diagram illustrating a surface structure of a package of yet another laser device on a side facing a mounting substrate according to an embodiment of the present disclosure;
FIG. 26 is a schematic structural diagram of a package of yet another laser device according to an embodiment of the present disclosure;
FIG. 27 is a schematic top-view structural diagram of yet another laser device according to an embodiment of the present disclosure;
FIG. 28 is a schematic top-view planar structural diagram of a package of yet another laser device according to an embodiment of the present disclosure;
FIG. 29 is a schematic top-view planar structural diagram of yet another laser device according to an embodiment of the present disclosure;
FIG. 30 is a schematic diagram illustrating a surface structure of a package of yet another laser device on a side facing a mounting substrate according to an embodiment of the present disclosure;
FIG. 31 is a schematic top-view planar structural diagram of yet another laser device according to an embodiment of the present disclosure;
FIG. 32 is a schematic top-view planar structural diagram of yet another laser device according to an embodiment of the present disclosure;
FIG. 33 is a schematic diagram illustrating an internal structure of a light emitting unit in a laser device according to an embodiment of the present disclosure;
FIG. 34 is a schematic cross-sectional structural diagram of a package in a laser device according to an embodiment of the present disclosure;
FIG. 35 is a schematic exploded structural diagram of a package in a laser device according to an embodiment of the present disclosure;
FIG. 36 is a schematic diagram illustrating an internal structure of a package in a laser device according to an embodiment of the present disclosure;
FIG. 37 is a schematic diagram illustrating an internal structure of a package in yet another laser device according to an embodiment of the present disclosure;
FIG. 38 is a schematic diagram illustrating an internal structure of a package in yet another laser device according to an embodiment of the present disclosure;
FIG. 39 is a schematic structural diagram of a laser apparatus according to an embodiment of the present disclosure;
FIG. 40 is a schematic structural diagram of a laser device according to an embodiment of the present disclosure.

### DETAILED DESCRIPTION

To make the objectives and implementations of the present disclosure clearer, the exemplary implementations of the present disclosure will be clearly and completely described below in conjunction with the accompanying drawings in the exemplary embodiments of the present disclosure. Apparently, the described exemplary embodiments are only some of the embodiments of the present disclosure, rather than all of the embodiments.

It should be noted that the brief description of terms in the present disclosure is only for the convenience of understanding the implementations described below, and is not intended to limit the implementations of the present disclosure. Unless otherwise specified, these terms should be understood according to their ordinary and usual meanings.

The terms "include" and "have" and any variations thereof are intended to cover but not exclude inclusion. For example, a product or device that includes a series of components is not necessarily limited to all the components explicitly listed, but may include other components not explicitly listed or inherent to such product or device.

In the present disclosure, unless otherwise explicitly specified and limited, the terms "installed", "connected", "coupled", "fixed", and the like should be understood in a broad sense. For example, they may be a fixed connection, a detachable connection, or an integral connection; they may be a mechanical connection or an electrical connection; they may be a direct connection or an indirect connection through an intermediate medium; they may be an internal communication between two elements or an interaction relationship between two elements, unless otherwise explicitly limited. For a person of ordinary skill in the art, the specific meanings of the above terms in the present disclosure can be understood according to specific circumstances.

In the present disclosure, unless otherwise explicitly specified and limited, a first feature being "on" or "under" a second feature may mean that the first and second features are in direct contact, or the first and second features are in indirect contact through an intermediate medium. Furthermore, a first feature being "above", "over", or "on top of" a second feature may mean that the first feature is directly above or obliquely above the second feature, or simply that the first feature is at a higher horizontal level than the second feature. A first feature being "below", "underneath", or "beneath" a second feature may mean that the first feature is directly below or obliquely below the second feature, or simply that the first feature is at a lower horizontal level than the second feature.

In the description of this specification, description with reference to the terms "one embodiment", "some embodiments", "example", "specific example", or "some examples" means that a specific feature, structure, material, or characteristic described in connection with the embodiment or example is included in at least one embodiment or example of the present disclosure. In this specification, the illustrative representations of the above terms are not necessarily directed to the same embodiment or example. Moreover, the described specific features, structures, materials, or characteristics may be combined in any suitable manner in any one or more embodiments or examples. Furthermore, a person skilled in the art may combine different embodiments or examples and features of different embodiments or examples described in this specification without contradicting each other.

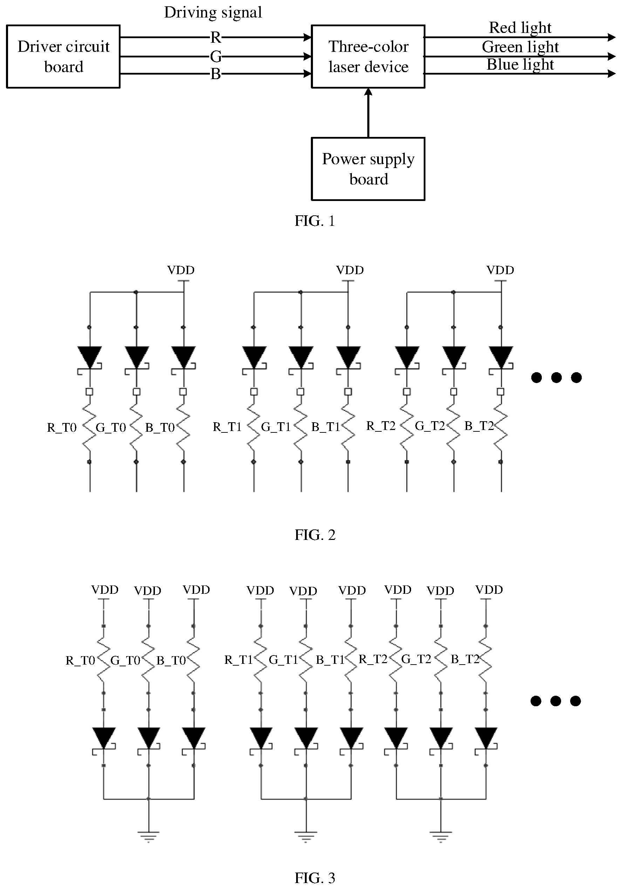

FIG. 1 is a schematic diagram illustrating an operating principle of a laser device in the related art. FIG. 2 is a circuit diagram illustrating a common-anode wiring scheme of a laser device in the related art. FIG. 3 is a circuit diagram illustrating a common-cathode wiring scheme of a laser device in the related art. As shown in FIG. 1, in the related art, a driver circuit board is used to transmit driving signals to a three-color laser device, and a power supply board is used to supply power to the laser device (e.g., providing an operating voltage VDD). When powered on, the laser device emits light based on the received driving signals. As shown in FIGS. 2 and 3, three-color light emitting chips (represented by diode symbols) form a three-color laser device. Resistors R_T, G_T, and B_T represent driving circuits for the three-color laser device. When multiple three-color laser devices are required to operate simultaneously to increase brightness, the number of driving circuits increases as the number of laser devices increases (e.g., resistors R_T0, G_T0, B_T0, ..., R_Tn, G_Tn, B_Tn as shown in FIGS. 2 and 3), leading to increased costs.

To solve the above technical problems, embodiments of the present disclosure provide a laser device and a laser apparatus. The laser device includes: a mounting substrate, including a connection pattern, a plurality of connection pads, and a plurality of intra-board connection lines, wherein at least four of the connection pads are electrically connected to the connection pattern via the plurality of intra-board connection lines; a light emitting unit, the light emitting unit including at least one package and a plurality of light emitting chips disposed within the at least one package, wherein the at least one package is provided with a conductive structure on a side thereof facing the mounting substrate, the connection pattern includes a conductive pattern corresponding to the light emitting unit, the light emitting unit is fixed on the corresponding conductive pattern and is electrically connected to the corresponding conductive pattern, at least one sidewall connection line is disposed within a sidewall of the at least one package, and at least one of the light emitting chips is electrically connected to one of the sidewall connection lines within a sidewall of a package that houses the light emitting chip; wherein the light emitting chips in the light emitting unit include light emitting chips having at least two different emission colors, the plurality of connection pads include a group of connection pads corresponding to each emission color of the light emitting chips in the light emitting unit, each group of connection pads includes two of the connection pads, and each group of connection pads is electrically connected to the light emitting chips of the corresponding color. With such an arrangement, the light emitting unit is fixed on the conductive pattern of the connection pattern of the mounting substrate, and the light emitting chips of each color are electrically connected to the corresponding two connection pads via the sidewall connection lines, the conductive structure, the conductive pattern, and the intra-board connection lines, thereby achieving independent power supply for light emitting chips of different colors. This solves the problem that the number of light emitting chips used is limited by the driving circuits, and the number of driving circuits does not increase as the number of light emitting chips increases, effectively improving the working efficiency of the driving circuits and reducing costs.

It should be noted that the light emitting unit described in the embodiments of the present disclosure refers to a minimum repeating unit that includes light emitting chips of each color in the laser device. In different implementations, the laser device may include only one light emitting unit, or may include a plurality of light emitting units. In one example, a plurality of light emitting units are arranged on the same substrate in a row/column/multiple rows and columns, and each light emitting unit has the same structure. In different implementations, in each light emitting unit, a plurality of light emitting chips of different colors may all be disposed in the same package, or may be respectively disposed in packages corresponding to each color, or may be distributed in a plurality of different packages in any other manner.

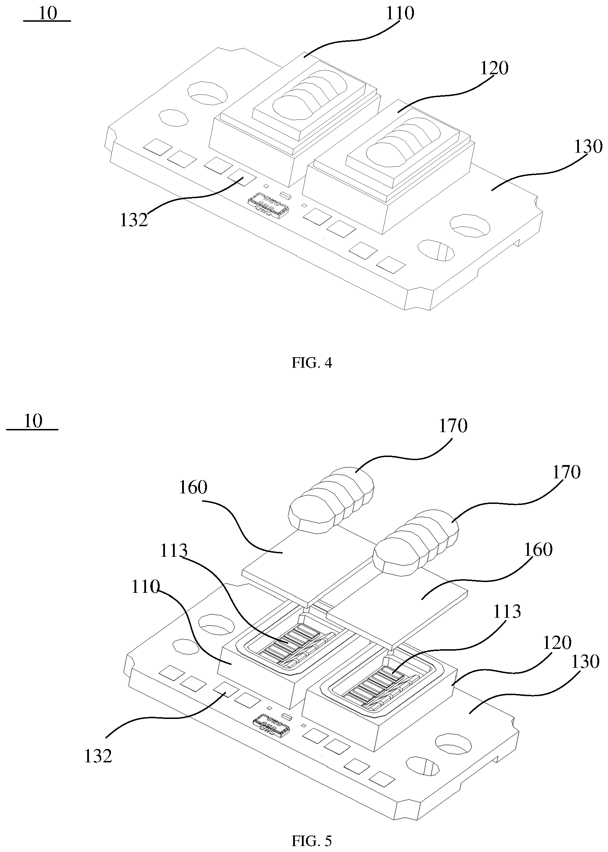

FIG. 4 is a schematic diagram illustrating an appearance structure of a laser device according to an embodiment of the present disclosure, and FIG. 5 is a schematic exploded structural diagram of a laser device according to an embodiment of the present disclosure. The laser device shown in FIGS. 4 and 5 is a laser device including only one light emitting unit having two packages. As shown in FIG. 4, the laser device 10 includes a mounting substrate 130 and a light emitting unit (including a first package 110 and a second package 120). The mounting substrate 130 includes a plurality of connection pads 1303 (eight are shown in FIG. 4 as an example). As shown in FIG. 5, a plurality of light emitting chips 113 are respectively disposed within the first package 110 and the second package 120 (five light emitting chips 113 arranged in a row are shown in FIG. 5 as an example). A light transmitting component 160 and a lens assembly 170 are provided on top of each package 110/120. The lens assembly 170 is used to compress the divergence angle of the divergent light beams emitted by the light emitting chips 113, so as to achieve collimation.

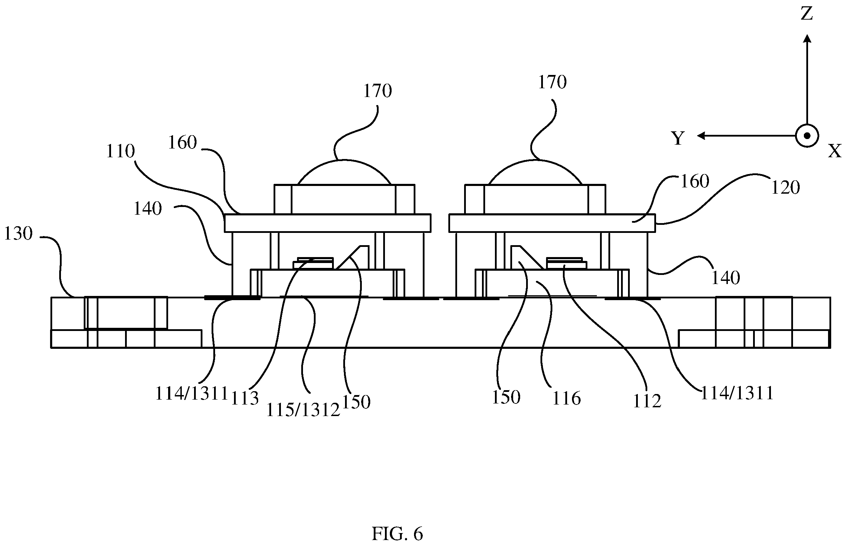

FIG. 6 is a schematic side cross-sectional structural diagram of a laser device according to an embodiment of the present disclosure. Referring to FIG. 6, the X-Y plane is a plane parallel to a plane where the mounting substrate is located, the Z-axis direction is a direction perpendicular to the plane where the mounting substrate is located, the X-axis direction is a direction in which the light emitting chips 113 are arranged in each package (i.e., the row direction of the light emitting chips 113 arranged in a row), and the Y-axis direction is a direction in which the two packages are arranged. As shown in FIG. 6, the mounting substrate 130 includes a connection pattern (including a conductive pattern corresponding to each light emitting unit in one-to-one correspondence, each conductive pattern including a plurality of transfer pads and a conductive base corresponding to each package in one-to-one correspondence; FIG. 6 shows one conductive pattern including two conductive bases 1312 and a plurality of transfer pads 1311). A sidewall 140 of each of the first package 110 and the second package 120, together with a package bottom plate 116 at a bottom thereof and the light transmitting component 160 at a top thereof, encloses a sealed space for accommodating the plurality of light emitting chips 113 and the plurality of reflection components 150 therein. Referring to FIGS. 5 and 6, a reflection component 150 is correspondingly disposed on a light output side of each light emitting chip 113 in each package. The reflection component 150 is used to reflect the laser beam emitted from the light emitting chip 113 to guide the laser beam toward the light transmitting component 160 and the lens assembly 170 at the top, so as to achieve emission of the laser beam from the laser device 10. In some examples, connection lines may be disposed in the package bottom plate 116 and/or the sidewall 140. In some examples, the package bottom plate 116 and/or the sidewall 140 are formed of a metal (such as a copper base material) or a ceramic material. In one example, the light output direction of the plurality of light emitting chips 113 is parallel to an upper surface of the package bottom plate 116. Therefore, the laser beam emitted from the light emitting chips 113 is also reflected by the reflection component 150 to change the light output direction, so that the laser beam is emitted upward in a direction away from the package bottom plate 116. The reflected laser light then sequentially passes through the light transmitting component 160 (such as a light transmitting glass) and exits through the lens assembly 170. The light transmitting component 160 is connected to an upper end of the sidewall 140 of the package, and is made of, for example, sapphire, which is welded to the upper end of the sidewall 140 of the ceramic package by AuSn soldering. In one example, the sealed space enclosed by the light transmitting component 160, the sidewall 140 of the package, and the package bottom plate 116 may be filled with nitrogen gas, so as to provide a reliable internal working environment for the light emitting chips of the laser device.

As shown in FIG. 6, each light emitting unit further includes a plurality of heat sinks 112 corresponding to the plurality of light emitting chips 113 in one-to-one correspondence. Each light emitting chip 113 is mounted (for example, by local soldering) on the conductive pattern corresponding to the light emitting unit in which it is located (the conductive base 1312 corresponding to the package in which it is located) via the corresponding heat sink 112. In addition, as shown in FIG. 6, each package is provided with a conductive structure (including a plurality of bottom pads 114) on a side thereof facing the mounting substrate 130. The plurality of transfer pads 1311 corresponding to each light emitting unit are connected to the plurality of bottom pads 114 of the conductive structure in one-to-one correspondence.

When the light emitting chips 113 are in operation, a large amount of heat is generated. The heat needs to be quickly dissipated to prevent heat accumulation from affecting the light emitting efficiency of the light emitting chips. As shown in FIG. 6, a heat sink 112 is disposed below each light emitting chip 113. The light emitting chip 113 is fixedly connected to the heat sink by soldering. The heat sink 112 may be made of a material having a higher thermal conductivity than oxygen-free copper, such as aluminum nitride. Utilizing its high thermal conductivity, the heat generated during the light emitting process of the light emitting chip 113 can be quickly conducted to the underlying copper heat-dissipating package bottom plate 116. The package bottom plate 116 is typically made of oxygen-free copper and uses its large heat dissipation area to quickly dissipate the heat generated by the light emitting chips 113 to the surrounding environment, thereby reducing the junction temperature of the light emitting chips 113. In some examples, the package bottom plate 116 may also form conductive lines in a regional range for transmitting driving current to the light emitting chips 113. The volume and weight of the package bottom plate 116 are much larger than those of the light emitting chips 113. The material of the heat sink 112 may also be selected from materials such as aluminum, copper, diamond copper, etc. Among them, insulating materials such as AlN and SiC are often used when there is an insulation requirement below the light emitting chips 113.

In one example, the light emitting chip 113 is soldered to the heat sink 112 via a solder layer. In some specific examples, the light emitting chip 113 is soldered using a high-precision eutectic soldering machine with an AuSn solder layer. The main components are Au and Sn materials, such as Au75Sn25 or Au80Sn20, which may be adjusted according to different specification requirements, with a thickness of approximately 1-10 µm.

In one example, the heat sink 112 includes a multi-layer structure. For example, along a direction away from the light emitting chip 113, it sequentially includes a Ti/Pt/Au layer, where the Au layer is adjacent to the AuSn solder layer, followed by the Pt and Ti layers. The Au layer is mainly used to facilitate soldering of gold wires. The Pt layer is disposed adjacent to the Au layer and serves a bonding function. The Ti layer, in addition to providing a bonding function together with the other two layers, also has a certain thermal conductivity.

The thicknesses of the Ti/Pt/Au three layers are determined according to practical applications, but in most cases are less than 1 µm, aiming to conduct heat to the sidewall 140 of the package as quickly as possible.

In some embodiments, the heat sink 112 has a relatively high thermal conductivity, so that when the light emitting chip 113 generates heat during light emission, the heat can be quickly conducted away, preventing damage to the light emitting chip 113 caused by the heat. For example, the material of the heat sink 112 may include one or more of aluminum nitride and silicon carbide.

Furthermore, for a light emitting chip 113, it is mounted on the heat sink 112 in a three-dimensional strip shape. The surface in contact with the heat sink 112 is a bottom surface, and an orthographic projection of the bottom surface on the surface of the heat sink 112 is rectangular. The light emitting surface of the light emitting chip 113 is a side surface perpendicular to the bottom surface, also referred to as a side light emitting surface. The light emitting surface of the light emitting chip 113 is rectangular. The emitted laser beam has different divergence angles along the short side direction and the long side direction of the rectangular light emitting surface. Typically, the fast axis direction and the slow axis direction of the laser beam correspond to directions of different divergence angles of the laser beam. The direction from which the light emitted from the light emitting surface has a larger divergence angle is usually referred to as the fast axis direction, and correspondingly, the direction with a smaller divergence angle is the slow axis direction.

In this example, the plurality of light emitting chips 113 are all light emitting chips 113 that emit red light. Since a red light emitting chip has two light emitting points on its light emitting surface, compared to the blue laser beam emitted from the light emitting surface of a blue light emitting chip and the green laser beam emitted from the light emitting surface of a green light emitting chip, the red laser beam has a larger divergence angle in both the fast axis direction and the slow axis direction.

As shown in FIG. 6, the plurality of light emitting chips 113 are respectively soldered to the package bottom plate 116 via the heat sinks 112. Since a portion of the metal wire of each of the plurality of light emitting chips 113 is connected to the light emitting chip to achieve electrical connection of one electrode of the light emitting chip, and another portion is connected to the corresponding heat sink 112, the region on the heat sink 112 for connecting the metal wire has a conductive relationship or a corresponding relationship with the other electrode of the light emitting chip 113. For each light emitting chip 113, by connecting two metal wires respectively to the light emitting chip itself and to the heat sink below the light emitting chip, an electrical connection relationship with the outside world can be achieved.

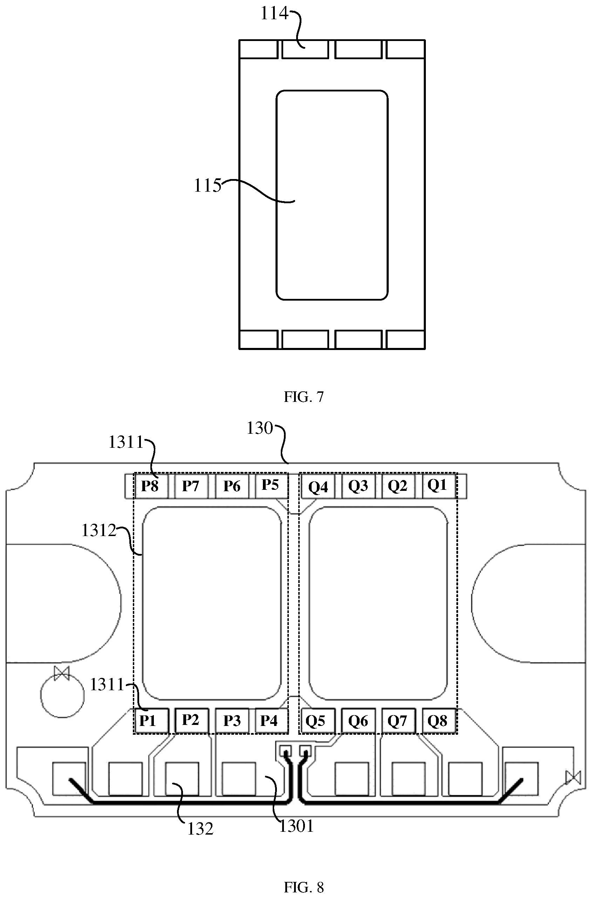

FIG. 7 is a schematic diagram illustrating a surface structure of a package of a laser device on a side facing a mounting substrate according to an embodiment of the present disclosure. FIG. 8 is a schematic top-view structural diagram of a mounting substrate in a laser device according to an embodiment of the present disclosure. Referring to FIG. 7, a conductive structure (including a plurality of bottom pads 114, eight bottom pads 114 are shown in FIG. 7 as an example) and a connection layer 115 are disposed on a side of the package facing the mounting substrate 130 (i.e., a lower surface of the package). In one example, the connection layer 115 is a metal film layer having a substantially rectangular shape. Referring to FIG. 8, the mounting substrate 130 includes a connection pattern (including a conductive pattern corresponding to each light emitting unit in one-to-one correspondence, each conductive pattern including a plurality of transfer pads and a conductive base corresponding to each package in one-to-one correspondence; FIG. 8 shows one conductive pattern including two conductive bases 1312 and sixteen transfer pads 1311), a plurality of connection pads 132 (eight connection pads 132 are shown in FIG. 8 as an example), and a plurality of intra-board connection lines 1301. The connection pads 132 are electrically connected to the transfer pads 1311 in the connection pattern via the intra-board connection lines 1301. The connection pads 132 are used to connect to driving circuits and a power supply (for example, the connection pads 132 may be connected to the power supply via connectors, flexible substrates, epoxy glass substrates, leaf spring terminals, or other structures). The conductive bases 1312 are structures for connecting the light emitting chips 113. In a top view, they have a substantially rectangular shape, and match the connection layer 115 in shape, size, and position. As an example, as shown in FIG. 8, among the eight connection pads 132 arranged in a row in FIG. 8, the second connection pad from the left is individually connected to a transfer pad 1311 labeled P1 via one intra-board connection line 1301, the third connection pad from the left is individually connected to a transfer pad 1311 labeled P2 via one intra-board connection line 1301, the fourth connection pad from the left is individually connected to a transfer pad 1311 labeled P3, a transfer pad 1311 labeled P4, and a transfer pad 1311 labeled Q5 via one intra-board connection line 1301, the second connection pad from the right is individually connected to a transfer pad 1311 labeled Q8 via one intra-board connection line 1301, the third connection pad from the right is individually connected to a transfer pad 1311 labeled Q7 via one intra-board connection line 1301, and the fourth connection pad from the right is individually connected to a transfer pad 1311 labeled Q6 via one intra-board connection line 1301. In addition, transfer pads 1311 labeled P5, P6, P7, P8, Q1, Q2, Q3, and Q4 are connected together via one intra-board connection line 1301.

In one example, referring to FIG. 8, bottoms of the first package and the second package are respectively provided with eight bottom pads 114 and one connection layer 115. A total of sixteen bottom pads 114 and two connection layers 115 at the bottoms of the packages are in contact with and electrically connected to one conductive pattern (including sixteen transfer pads 1311 and two conductive bases 1312) on the mounting substrate 130 - the eight bottom pads in each package are electrically connected to the corresponding eight transfer pads 1311 in one-to-one correspondence, and the connection layer 115 in each package is electrically connected to the corresponding conductive base 1312.

In the embodiments of the present disclosure, the light emitting chips 113 in each light emitting unit of the laser device 10 include light emitting chips having at least two different emission colors. The connection pads 132 on the mounting substrate 130 include a group of connection pads 132 corresponding to each emission color of the light emitting chips in each light emitting unit. Each group of connection pads 132 includes two connection pads 132, and each group of connection pads 132 is electrically connected to the light emitting chips of the corresponding color. In one example, referring to FIG. 6, the light emitting chips 113 of each color are sequentially connected to the corresponding group of connection pads 132 via the sidewall connection lines 117 (and/or the connection lines disposed in the package bottom plate 116), the bottom pads 114, the transfer pads 1311, and the intra-board connection lines 1301, thereby achieving independent power supply for the light emitting chips 113 of each color. Each group of connection pads 132 includes two connection pads 132.

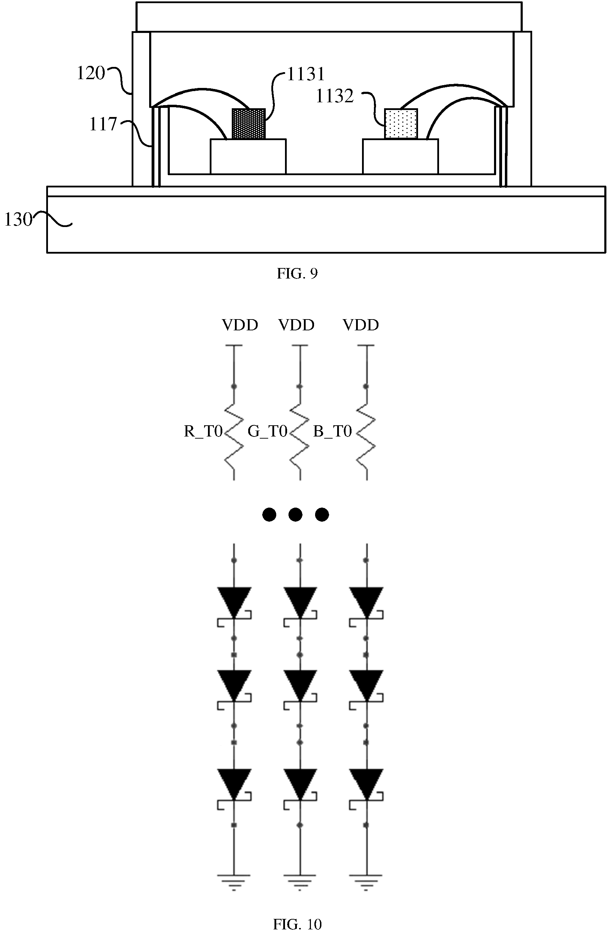

FIG. 9 is a schematic side cross-sectional structural diagram of a package in a laser device according to an embodiment of the present disclosure. Referring to FIG. 9, the plurality of light emitting chips 113 of the second package 120 include a first-type light emitting chip 1131 and a second-type light emitting chip 1132. The first-type light emitting chip 1131 emits blue laser light, and the second-type light emitting chip 1132 emits red or green laser light. The first-type light emitting chip 1131 is electrically connected to the corresponding two connection pads 132, and the second-type light emitting chip 1132 is electrically connected to the corresponding two connection pads 132. Therefore, at least four connection pads 132 need to be provided on the mounting substrate 130. It should be noted that FIG. 9 only exemplarily shows a laser device including two types of light emitting chips having different emission colors, but does not limit the number of color types of the light emitting chips included in the laser device according to the embodiments of the present disclosure. In another example, the laser device includes three color types of light emitting chips, which respectively emit laser light of different colors. All three types of light emitting chips 113 are electrically connected to the corresponding connection pads 132 via the sidewall connection lines 117 of the second package 120, and are independently powered.

FIG. 10 is a schematic circuit diagram of a laser device according to an embodiment of the present disclosure. Referring to FIG. 10, the laser device includes three types of light emitting chips 113 of red, green, and blue (RGB). The light emitting chips 113 of each color are connected in series with a corresponding power supply VDD and a driving circuit R_T0, G_T0, or B_T0. Compared with the circuit structure shown in FIG. 2 or FIG. 3, it can be seen that in the embodiments of the present disclosure, regardless of how the number of light emitting chips 113 increases, the number of required driving circuits does not change. Thus, the problem that the number of light emitting chips used is limited by the driving circuits can be solved, the working efficiency of the driving circuits can be effectively improved, and costs can be reduced.

In some embodiments, to achieve independent power supply and meet miniaturization design requirements, the mounting substrate 130 is a copper substrate (e.g., a copper printed circuit board). The copper substrate is a single-sided board (i.e., wiring on one side only), so that the back side of the copper substrate has sufficient space for heat dissipation, which is beneficial for heat dissipation of the laser device. This embodiment does not limit the dimensions of the mounting substrate 130, which can be flexibly set according to requirements. In some possible implementations, the mounting substrate 130 is a 15.8 mm × 26 mm copper substrate with a board thickness of 1.6 mm.

In some possible implementations, a thickness of an electrical connection portion on a surface of the mounting substrate 130 close to the package is 2 oz, about 70 micrometers. In one example, a thickness of any one or more of the intra-board connection lines 1301, the connection pads 132, the transfer pads 1311, and the conductive bases 1312 is 70 micrometers.

In some possible implementations, as shown in FIG. 8, on a plane perpendicular to the mounting substrate 130, orthographic projections of the connection pads 132 at least partially overlap with orthographic projections of the intra-board connection lines 1301, orthographic projections of the connection pattern (the transfer pads 1311 and the conductive bases 1312) at least partially overlap with the orthographic projections of the intra-board connection lines 1301, and orthographic projections of the conductive structure (the bottom pads 114 overlapping with the transfer pads 1311) at least partially overlap with the orthographic projections of the connection pattern (the transfer pads 1311 and the conductive bases 1312). The connection pads 132, the intra-board connection lines 1301, and the connection pattern (the transfer pads 1311 and the conductive bases 1312) are all located on a surface of the mounting substrate 130 facing the light emitting unit.

In a direction perpendicular to the plane where the mounting substrate 130 is located, the connection pads 132 and the intra-board connection lines 1301 have overlapping regions, which are connection regions between the connection pads 132 and the intra-board connection lines 1301. The larger the overlapping area between the connection pads 132 and the intra-board connection lines 1301, the more favorable it is for improving the stability of the electrical connection and reducing contact resistance. Situations where the connection pads 132 at least partially overlap with the intra-board connection lines 1301 include: the orthographic projection of the connection pad 132 is completely within the orthographic projection of the intra-board connection line 1301 (as shown in FIG. 8), or the connection pad 132 partially overlaps with the intra-board connection line 1301 while another portion does not overlap.

In a direction perpendicular to the plane where the mounting substrate 130 is located, the connection pattern (the transfer pads 1311 and the conductive bases 1312) and the intra-board connection lines 1301 have overlapping regions, which are connection regions between the connection pattern (the transfer pads 1311 and the conductive bases 1312) and the intra-board connection lines 1301. The larger the overlapping area between the connection pattern (the transfer pads 1311 and the conductive bases 1312) and the intra-board connection lines 1301, the more favorable it is for improving the stability of the electrical connection and reducing contact resistance. Situations where the connection pattern (the transfer pads 1311 and the conductive bases 1312) at least partially overlaps with the intra-board connection lines 1301 include: the orthographic projection of the transfer pad 1311 is completely within the orthographic projection of the intra-board connection line 1301 (as shown in FIG. 8), or the transfer pad 1311 partially overlaps with the intra-board connection line 1301 while another portion does not overlap.

As shown in FIG. 8, within the plane where the mounting substrate 130 is located, the connection pads 132 are located on a same side edge of the mounting substrate 130, i.e., on a same side of all packages. This not only ensures miniaturization of the entire laser device, but also makes the appearance of the laser device more aesthetically pleasing, and can enhance the operability of manual soldering. In other possible implementations, the connection pads 132 may also be distributed on two opposite sides of the packages, which can still achieve independent power supply for the light emitting chips of each color, but is unfavorable for miniaturization.

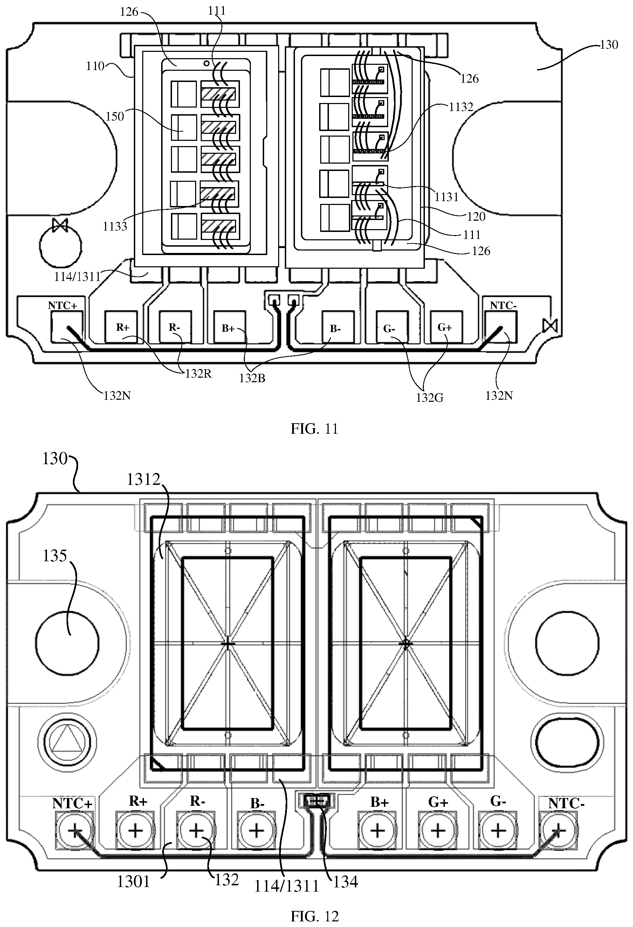

FIG. 11 is a schematic top-view planar structural diagram of a laser device according to an embodiment of the present disclosure. In this embodiment of the present disclosure, the laser device includes three color types of light emitting chips. Each light emitting chip is one of a first-type light emitting chip 1131, a second-type light emitting chip 1132, and a third-type light emitting chip 1133, each having a different emission color. As an example, referring to FIG. 9, the light emitting chips 113 of a same color located within a same package are connected in series and are respectively connected to two connection pads of a corresponding group of connection pads 132, so as to be respectively connected to corresponding driving circuits R_T0, G_T0, or B_T0 (and a power supply VDD). As an example, referring to FIG. 11, the first package 110 encapsulates the first-type light emitting chips 1131 and the second-type light emitting chips 1132, and the second package 120 encapsulates the third-type light emitting chips 1133. Center wavelengths of the first-type light emitting chips 1131, the second-type light emitting chips 1132, and the third-type light emitting chips 1133 are different from each other, and they respectively emit laser beams of different colors. Moreover, the center wavelength of the third-type light emitting chips 1133 is greater than the center wavelengths of the first-type light emitting chips 1131 and the second-type light emitting chips 1132, and the center wavelength of the first-type light emitting chips 1131 is less than the center wavelength of the second-type light emitting chips 1132. As an example, the second package 120 encapsulates five third-type light emitting chips 1133 having a red emission color, and the second package 120 encapsulates two first-type light emitting chips 1131 having a blue emission color and three second-type light emitting chips 1132 having a green emission color. In this embodiment of the present disclosure, a total number of the first-type light emitting chips 1131 and the second-type light emitting chips 1132 is the same as a number of the third-type light emitting chips 1133.

Due to differences in light emission mechanisms, the photoelectric conversion efficiency and photothermal conversion efficiency of laser chips of different colors vary. For example, red laser light emitting chips have high thermal conversion power but relatively low light emission efficiency, and the visual sensory function is lower than that of green, meaning that under the same light emission power, the human eye perceives green more easily. To meet the white balance color matching and brightness required for image display, the numbers of the above three types of light emitting chips may be set such that the number of red light emitting chips is greater than both the number of green light emitting chips and the number of blue light emitting chips. Furthermore, the number of green light emitting chips is greater than the number of blue light emitting chips. As an example, the laser device shown in FIG. 11 includes 2 blue light emitting chips, 3 green light emitting chips, and 5 red light emitting chips.

In one example, the lens assembly 170 is disposed above the light transmitting component 160, for example, connected to the light transmitting component by dispensing adhesive around the periphery. In this example, the lens assembly 170 is an integrally formed plurality of collimating lens units, used to compress the divergence angle of the laser beams emitted from the laser light emitting chips, which have a relatively large divergence angle, thereby achieving beam collimation. In some specific implementations, for process uniformity, lens assemblies having the same curvature and dimensions may be used for the first-type light emitting chips, the second-type light emitting chips, and the third-type light emitting chips. In this example, since the number of third-type light emitting chips is equal to the sum of the numbers of first-type light emitting chips and second-type light emitting chips, the same lens assembly can be used for these two light emitting units, thereby reducing mold opening costs and improving the versatility of optical components. In this example, the curvature of the lens assembly 170 may be set corresponding to the third-type light emitting chips, i.e., the red light emitting chips. This is because red light emitting chips have two light emitting points, and their divergence angles in both the fast axis direction and the slow axis direction are larger than those of the other two types of light emitting chips in the corresponding directions. The divergence angle of the red laser beam has a significant impact on the combined light divergence angle. Therefore, when setting a universal lens assembly, priority is given to collimating the divergence angle of the red light emitting chips. This lens assembly is then applied to the light output paths above the red light emitting chips, as well as to the light output paths above the blue and green light emitting chips.

In some examples, lens assemblies having corresponding curvatures may also be separately provided for different types or colors of light emitting chips, so as to correspondingly reduce the divergence angle of the beam of each color to achieve a better collimation effect. In some examples, the third-type light emitting chips include a plurality of red light emitting chips having different center wavelengths. For instance, take the third-type light emitting chips including 5 red light emitting chips as an example. In some specific examples, the 5 red light emitting chips emit beams having at least two different center wavelengths, such as center wavelengths of 639 nm and 643 nm, or 643 nm and 647 nm, or 639 nm and 647 nm. In other examples, the 5 light emitting chips may also emit beams having three different center wavelengths, including corresponding center wavelengths of 639 nm, 643 nm, and 647 nm. The numbers of red light emitting chips corresponding to the three different center wavelengths may be 1, 2, and 2, or 2, 2, and 1. This is merely an illustrative example; the sum of the numbers of light emitting chips corresponding to the different center wavelengths need only satisfy the aforementioned number of 5, and the specific number of light emitting chips for each center wavelength is not particularly limited. For laser beams of the same color, by providing a plurality of center wavelengths, the coherence characteristics between the laser beams can be reduced.

In some examples, light emitting chips having different center wavelengths are arranged in an order of increasing center wavelengths, or two light emitting chips having different center wavelengths are arranged adjacently, while two light emitting chips having the same center wavelength are arranged with intervals.

In one example, within the second package, along a longitudinal direction of the second package, 2 blue light emitting chips and 3 green light emitting chips are sequentially arranged. In some specific examples, the center wavelength of the blue light emitting chips is 465 nm, and the center wavelength of the green light emitting chips is 525 nm. Within the second package, along a longitudinal direction of the second package, the center wavelengths of the sequentially arranged red light emitting chips exhibit a decreasing trend. The first package and the second package are arranged in parallel, and dimensions in the length, width, and height directions of the packages are substantially the same. In a direction perpendicular to the longitudinal direction of the packages, the blue light emitting chips are disposed adjacent to the red light emitting chips having longer center wavelengths among the plurality of red light emitting chips, and the green light emitting chips are disposed adjacent to the red light emitting chips having shorter center wavelengths among the plurality of red light emitting chips. Since the longer the center wavelength of a red light emitting chip, the higher the thermal conversion efficiency, i.e., the more prone it is to generate heat, while the thermal efficiency of blue light emitting chips is lower than that of green light emitting chips and red light emitting chips, under the same driving current, the heat generation of blue light emitting chips is relatively insignificant. Therefore, in the dual-package three-color laser device provided in this example, the blue light emitting chips in the first package are disposed adjacent to the red light emitting chips having longer center wavelengths in the second package, and the green light emitting chips in the first package are disposed adjacent to the red light emitting chips having relatively shorter center wavelengths in the second package. For the laser device as a whole, the heat distribution is relatively balanced, which facilitates heat dissipation of the laser device as a whole and reduces the difficulty of heat control.

Moreover, since the light emission efficiency of red light emitting chips deteriorates under the influence of temperature, with the above arrangement, heat accumulation in the thermal environment where at least the red light emitting chips having longer center wavelengths are located is less likely to rise rapidly. This is because, in addition to the red light emitting chips themselves, the thermal efficiency of the blue light emitting chips adjacent thereto is relatively low, making rapid thermal changes less likely to occur. This is beneficial for stabilizing the light emission efficiency of the red light emitting chips and prevents the color of the red laser beam from shifting.

In some possible implementations, a number of connection pads 132 corresponding to each package is twice a number of color types of the light emitting chips 113 in the package. Two connection pads 132 in each group of connection pads 132 are a positive polarity pad and a negative polarity pad, respectively. Two connection pads 132 in a group of connection pads 132 connecting the light emitting chips 113 of a same color are adjacent to each other. In addition, in some possible implementations, within each light emitting unit, among all the connection pads 132 connecting the light emitting chips 113, two adjacent connection pads 132 are such that one is a positive polarity pad and the other is a negative polarity pad.

As shown in FIG. 11, as an example, a number of connection pads 132 corresponding to the first package 110 is twice a number of color types of the light emitting chips 113 in the package, i.e., two; a number of connection pads 132 corresponding to the second package 120 is twice a number of color types of the light emitting chips 113 in the package, i.e., four; a group of connection pads 132R corresponding to the third-type light emitting chips 1133 in the first package 110 includes a red positive polarity pad R+ and a red negative polarity pad R-, a group of connection pads 132B corresponding to the first-type light emitting chips 1131 in the second package 120 includes a blue positive polarity pad B+ and a blue negative polarity pad B-, a group of connection pads 132G corresponding to the second-type light emitting chips 1132 in the second package 120 includes a green positive polarity pad G+ and a green negative polarity pad G-, and among these connection pads 132, two connection pads of the same group are adjacent to each other, and two adjacent connection pads 132 always form a combination of one positive polarity pad and one negative polarity pad.

Referring to FIG. 11, as an example, four third-type light emitting chips 1133 in the first package 110 are connected in series as one path via metal wires 111 (the material is, for example, gold Au). Two ends of the series circuit are respectively electrically connected to step portions 126 on two sides. An upper surface of the step portion 126 is provided with a metal film. The metal film is electrically connected to a corresponding bottom pad 114 in the conductive structure via a sidewall connection line 117. The bottom pad 114 is electrically connected to a corresponding transfer pad 1311 in the conductive pattern of the connection pattern. The transfer pad 1311 is electrically connected to a corresponding connection pad 132R via an intra-board connection line 1301, thereby achieving electrical connection between the third-type light emitting chips 1133 and the corresponding group of connection pads 132R. Two first-type light emitting chips 1131 in the second package 120 are connected in series as one path via metal wires 111. Two ends of the series circuit are electrically connected to a metal film on an upper surface of the step portion 126, and are electrically connected to a corresponding bottom pad 114 in the conductive structure via a sidewall connection line 117. The bottom pad 114 is electrically connected to a corresponding transfer pad 1311 in the conductive pattern of the connection pattern. The transfer pad 1311 is electrically connected to a corresponding connection pad 132B via an intra-board connection line 1301, thereby achieving electrical connection between the first-type light emitting chips 1131 and the corresponding group of connection pads 132B. Three second-type light emitting chips 1132 in the second package 120 are connected in series as one path via metal wires 111. Two ends of the series circuit are electrically connected to another metal film on the upper surface of the step portion 126, and are electrically connected to a corresponding bottom pad 114 in the conductive structure via a sidewall connection line 117. The bottom pad 114 is electrically connected to a corresponding transfer pad 1311 in the conductive pattern of the connection pattern. The transfer pad 1311 is electrically connected to a corresponding connection pad 132G via an intra-board connection line 1301, thereby achieving electrical connection between the first-type light emitting chips 1131 and the corresponding group of connection pads 132G.

It should be noted that the above exemplarily shows a laser device including two packages, but the embodiments of the present disclosure are not limited thereto. In other possible implementations, the laser device 10 includes one package, and the first-type light emitting chips 1131, the second-type light emitting chips 1132, and the third-type light emitting chips 1133 are located within the same package; alternatively, the laser device 10 includes three packages, and the first-type light emitting chips 1131, the second-type light emitting chips 1132, and the third-type light emitting chips 1133 are respectively located in three packages, with light emitting chips 113 of the same emission color being located within the same package.

It should also be noted that a method for leading out the light emitting chips 113 in the package may be forming a metal film conductive region on an inner wall surface of the sidewall 140 of the package, the conductive region being used for soldering gold wires, and the conductive region being communicated with the sidewall connection line 117. When the conductive region connects the positive electrode and the negative electrode of the light emitting chip, or the anode and the cathode, there are two such conductive regions which are not communicated with each other. The two conductive regions are communicated with two traces of opposite polarities inside the package. Another leading-out method may be that the sidewall 140 of the package is inwardly formed with a step portion, such as the step portion 126 shown in FIG. 6, with a metal film conductive region provided on a surface thereof. By providing the step portion 126, the length of required metal wires can be shortened, or the difficulty of the soldering process between the metal wires and the metal conductive region can be reduced. In some examples, the package is made of a ceramic material, and the package bottom plate 116 is made of oxygen-free copper. When the package is disposed on the mounting substrate 130, only a region on the mounting substrate 130 corresponding to the package is provided with pads, while a region corresponding to the package bottom plate is an insulating region. In some examples, the sidewall connection line 117 of the first package may also be located within the sidewall 140 of the package and the package bottom plate 116. The material of the sidewall connection line 117 may be a metal material tungsten, which has good electrical conductivity.

In the example of FIG. 11, different types of light emitting chips respectively have their own electrode pairs, i.e., different types of light emitting chips are independently powered, sharing neither a common anode nor a common cathode. Therefore, at a side edge position of the mounting substrate 130, there are respectively provided an anode R+ and a cathode R- corresponding to the red light emitting chips, an anode B+ and a cathode B- corresponding to the blue light emitting chips, and an anode G+ and a cathode G-corresponding to the green light emitting chips. Different types or colors of light emitting chips are independently powered, which can improve the reliability of power supply. Moreover, for the mounting substrate, the versatility is improved, and the number of chips disposed in the package is selectable. For example, in a volume that can accommodate up to 5 chips, 3 chips or 5 chips can be disposed. Furthermore, the number of light emitting chips of the same color disposed is also flexible. For example, in the first package, the numbers of blue light emitting chips and green light emitting chips disposed can be 2 and 3, or 1 and 4, or both 2, but they can all be respectively electrically connected to the corresponding electrode pair pad positions via traces inside the package.

FIG. 12 is a schematic top-view planar structural diagram of another laser device according to an embodiment of the present disclosure. Referring to FIG. 12, similar to the laser device shown in FIG. 11, the mounting substrate 130 includes four groups of connection pads 132, which are: a thermistor positive polarity pad NTC+ and a thermistor negative polarity pad NTC-, a red positive polarity pad R+ and a red negative polarity pad R-, a blue positive polarity pad B+ and a blue negative polarity pad B-, and a green positive polarity pad G+ and a green negative polarity pad G-. Different from the laser device shown in FIG. 11, in order to prevent short-circuit between positive and negative electrodes caused by soldering errors, positions of the connection pads 132 are arranged according to a principle that same polarities are adjacent. From left to right, the arrangement order of the eight connection pads 132 is: thermistor positive polarity pad NTC+, red positive polarity pad R+, red negative polarity pad R-, blue negative polarity pad B-, blue positive polarity pad B+, green positive polarity pad G+, green negative polarity pad G-, and thermistor negative polarity pad NT-. That is, the thermistor positive polarity pad NTC+ is adjacent to the red positive polarity pad R+, the red negative polarity pad R- is adjacent to the blue negative polarity pad B-, the blue positive polarity pad B+ is adjacent to the green positive polarity pad G+, and the green negative polarity pad G- is adjacent to the thermistor negative polarity pad NTC-.

In the embodiments of the present disclosure, the type of the connection pads 132 may be, for example, a cross-shaped pad (as shown in FIG. 12), or any other type of pad known to those skilled in the art.

In some possible implementations, as shown in FIG. 12, the laser device further includes a thermistor 134. The thermistor 134 is connected to a corresponding group of connection pads 132 via connection lines. The thermistor 134 is used to detect the heating condition of the light emitting chips. The thermistor 134 includes a negative temperature coefficient (NTC) thermistor, or other types of thermistors known to those skilled in the art, which is not limited herein.

Exemplarily, as shown in FIG. 12, the thermistor 134 is located on a side of the conductive base 1312 close to the connection pads 132. The eight connection pads 132 are symmetrically distributed on two sides of the thermistor 134. A group of connection pads 132 corresponding to the thermistor 134 (i.e., NTC+ and NTC-) are located at the outermost sides. Two ends of the thermistor 134 are respectively connected to the thermistor positive polarity pad NTC+ and the thermistor negative polarity pad NTC- via corresponding connection lines on the mounting substrate 130.

In one example, the third-type light emitting chips 1133 emit red laser light, with a corresponding emission wavelength range of 6113 nm to 760 nm; the first-type light emitting chips 1131 emit blue laser light, with a corresponding emission wavelength range of 435 nm to 450 nm; the second-type light emitting chips 1132 emit green laser light, with a corresponding emission wavelength range of 492 nm to 577 nm. In other possible implementations, one or more of the first-type light emitting chips 1131, the second-type light emitting chips 1132, and the third-type light emitting chips 1133 may also emit laser light of other colors.

Referring to FIG. 12, for assembly needs, positioning holes 135 are generally provided on the mounting substrate 130. When a distance between the package and the positioning hole 135 is compressed to 0.5 mm, traces cannot be arranged. Therefore, in this embodiment, the bottom pads 114 may be provided only on a side of the package close to the connection pads 132. The bottom pads 114 are electrically connected to the corresponding connection pads 132 via the transfer pads 1311 located on a side of the mounting substrate 130 close to the connection pads 132 and the intra-board connection lines 1301.

In other possible implementations, under the condition that distances between the positioning holes 135 and the packages and distances between the packages satisfy a minimum trace width, the bottom pads 114 may also be provided on a side of the package away from the connection pads 132. In this case, intra-board connection lines 1301 may also be provided in a region between the positioning holes 135 and the packages on the mounting substrate 130, and/or in a region between two packages on the mounting substrate 130. Thus, transfer pads 1311 that are close to each other can be interconnected via the above intra-board connection lines 1301 and then electrically connected to the connection pads 132, thereby increasing the trace width and reducing resistance.

Exemplarily, as shown in FIG. 12, the laser device includes two packages (i.e., a first package 110 and a second package 120). Eight connection pads 132 are located on a same side of the two packages. Each package is provided with four bottom pads 114 on a side close to the connection pads 132. The mounting substrates corresponding to the first package 110 and the second package 120 are shown in FIG. 8. Referring to FIG. 8 and FIG. 12, in this laser device, a transfer pad 1311 labeled P1 is connected to the red positive polarity pad R+ via an intra-board connection line 1301; a transfer pad 1311 labeled P2 is connected to the red negative polarity pad R- via an intra-board connection line 1301; transfer pads 1311 labeled P3, P4, and Q5 are connected to the blue negative polarity pad B- via an intra-board connection line 1301; a transfer pad 1311 labeled Q6 is connected to the blue positive polarity pad B+; a transfer pad 1311 labeled Q7 is connected to the green positive polarity pad G+ via an intra-board connection line 1301; a transfer pad 1311 labeled Q8 is connected to the green negative polarity pad G-.

Exemplarily, as shown in FIG. 12, due to limitations of routing space and the addition of the thermistor 134, it is difficult to route between the transfer pad 1311 labeled Q5 and the blue negative polarity pad B-. Doing so would either reduce the area of other routings, or cause overlap between the routing and the thermistor, leading to a short circuit. Therefore, by connecting the transfer pads 1311 labeled P3 and P4 and the transfer pad 1311 labeled Q5 to the blue negative polarity pad B- via the same intra-board connection line 1301, on one hand, the trace width is increased, thereby reducing resistance and helping to improve the light emission intensity of the light emitting chips 113; on the other hand, it does not affect the placement positions of the thermistor 134 and the connection pads 132, making the overall structure appear more compact.

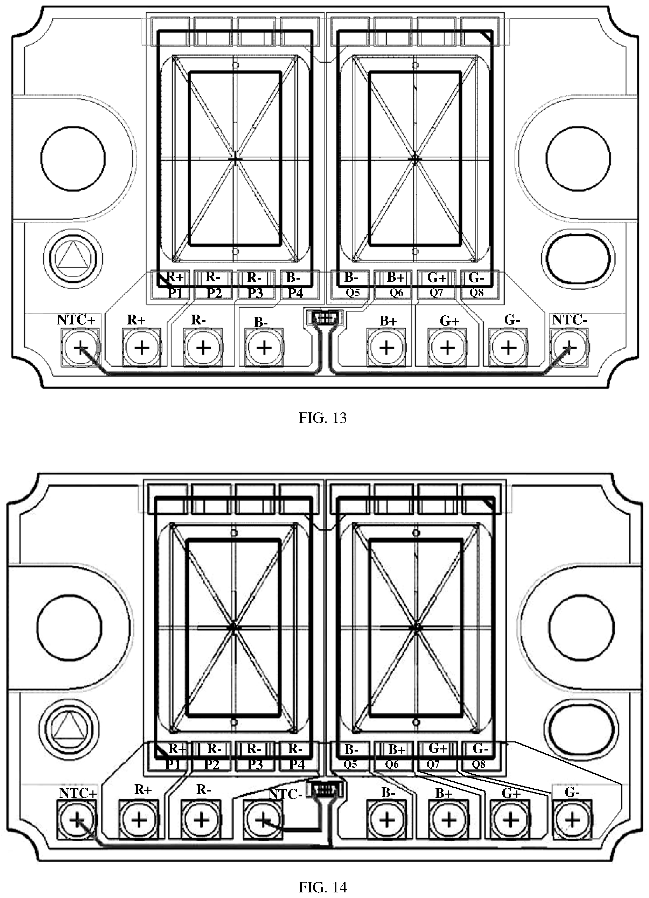

FIG. 13 is a schematic top-view planar structural diagram of yet another laser device according to an embodiment of the present disclosure. As another example, referring to FIG. 13, the transfer pad 1311 labeled P4 and the transfer pad 1311 labeled Q5 are electrically connected to the blue negative polarity pad B- via the same intra-board connection line 1301, thereby achieving electrical connection between the blue light emitting chips and the blue negative polarity pad B-; the transfer pad 1311 labeled P3 and the transfer pad 1311 labeled P2 are electrically connected to the red negative polarity pad R- via the same intra-board connection line 1301, thereby achieving electrical connection between the red light emitting chips and the red negative polarity pad R-. With such an arrangement, the trace widths of both the red negative polarity pad R- and the blue negative polarity pad B- can be doubled, thereby reducing resistance and improving the light emission brightness of the light emitting chips 113, while not affecting the placement positions of the thermistor 134 and the connection pads 132, making the overall structure appear more compact.

FIG. 14 is a schematic top-view planar structural diagram of yet another laser device according to an embodiment of the present disclosure. As another example, referring to FIG. 14, using the position of the thermistor as a boundary, only the red positive polarity pad R+ and the red negative polarity pad R- may be disposed on a left side thereof, while the blue negative polarity pad B-, the blue positive polarity pad B+, the green positive polarity pad G+, and the green negative polarity pad G- are all disposed on a right side thereof, and are substantially aligned with the bottom pads of the packages to ensure a relatively uniform trace width. Under this structure, the thermistor positive polarity pad NTC+ and the thermistor negative polarity pad NTC-may both be disposed on the left side. With such an arrangement, the bottom pads 114 of each package can be directly electrically connected to their adjacent connection pads 132. However, the traces between the connection pads 132 and the thermistor 134 need to be re-adjusted. For example, space on a lower side of the mounting substrate 130 may need to be increased to accommodate this portion of traces. Alternatively, the thermistor positive polarity pad NTC+ and the thermistor negative polarity pad NTC- are still respectively disposed on the left and right sides, and the numbers of connection pads 132 on the two sides are different. Either the area of the connection pads 132 on the right side is reduced, which may lead to decreased soldering reliability, or the area of the mounting substrate 130 on the right side is increased, which is unfavorable for miniaturization.

In other possible implementations, if the space requirement of the thermistor is not considered, the transfer pads 1311 corresponding to various light emitting chips 113 may be distributed in alignment with the bottom pads of the packages at equal intervals.

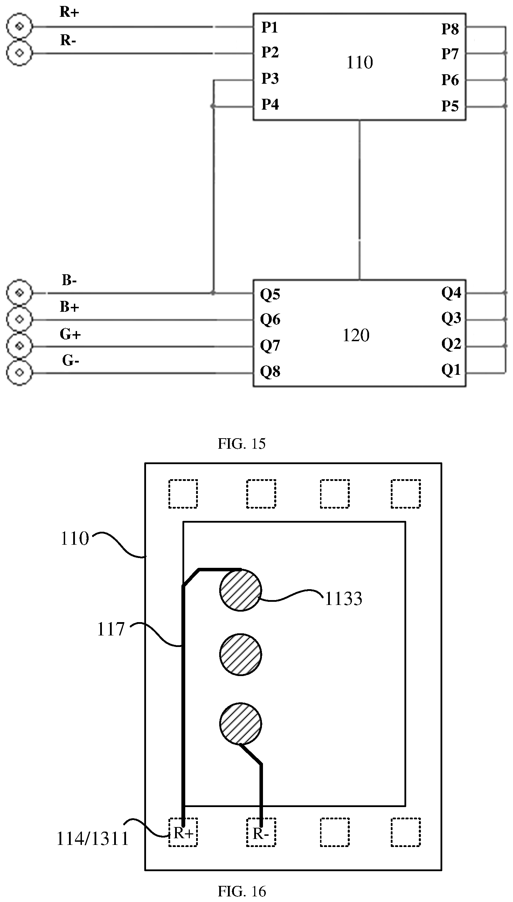

FIG. 15 is a schematic diagram illustrating a circuit connection relationship of a package of yet another laser device according to an embodiment of the present disclosure. Exemplarily, as shown in FIG. 15, the first package 110 and the second package 120 have the same structure. The second package 120 is obtained by rotating the first package 110 clockwise by 180°. The connection relationships thereof are the same as those shown in FIG. 8 and FIG. 11, and are not repeated here.

FIG. 16 is a schematic diagram illustrating an internal electrical connection relationship of a package of yet another laser device according to an embodiment of the present disclosure. Referring to FIG. 16, exemplarily, the first package 110 is provided with three third-type light emitting chips 1133 therein. All of the third-type light emitting chips 1133 are connected in series as one path (not shown in FIG. 16). A negative electrode and a positive electrode of the series-connected third-type light emitting chips 1133 are respectively connected to bottom pads 114 provided at a bottom of the first package 110 via sidewall connection lines 117 within the first package 110. The bottom pads 114 are electrically connected to transfer pads 1311 of the mounting substrate 130.

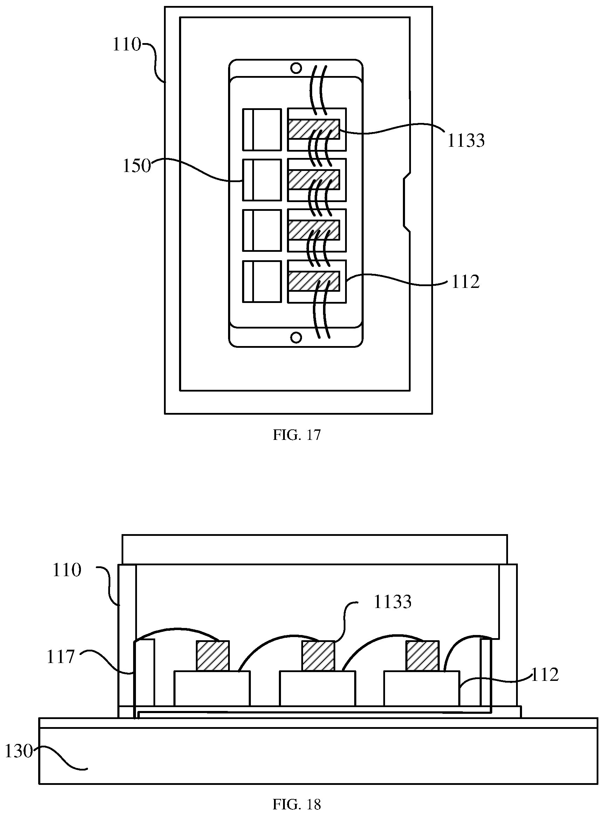

FIG. 17 is a schematic diagram illustrating an internal structure of a package of yet another laser device according to an embodiment of the present disclosure. Referring to FIG. 17, exemplarily, the first package 110 is provided with four third-type light emitting chips 1133 therein. All of the third-type light emitting chips 1133 are connected in series as one path via metal wires. The third-type light emitting chips 1133 are mounted on corresponding heat sinks 112, and corresponding reflection components 150 are provided on one side thereof.

FIG. 18 is a schematic side cross-sectional structural diagram of a package of yet another laser device according to an embodiment of the present disclosure. Referring to FIG. 18, exemplarily, the first package 110 is provided with three third-type light emitting chips 1133 therein. Each third-type light emitting chip 1133 is mounted on a corresponding heat sink 112. All of the third-type light emitting chips 1133 are connected in series as one path via metal wires. A negative electrode and a positive electrode of the series-connected third-type light emitting chips 1133 are respectively connected to the outside of the package via sidewall connection lines 117 within the first package 110.

In some possible implementations, the first package 110 is provided with four or three third-type light emitting chips 1133 therein. All of the third-type light emitting chips 1133 are connected in series as one path. A negative electrode and a positive electrode of the series-connected third-type light emitting chips 1133 are respectively connected to bottom pads 114 provided at a bottom of the first package 110 via sidewall connection lines 117 within the first package 110. The bottom pads 114 are electrically connected to transfer pads 1311 of the mounting substrate 130. The transfer pads 1311 are electrically connected to connection pads 132 via intra-board connection lines 1301, thereby achieving electrical connection between the third-type light emitting chips and the mounting substrate 130. As an example, the sidewall connection lines 117 within the first package 110 are located in the sidewall 140 and the package bottom plate 116.

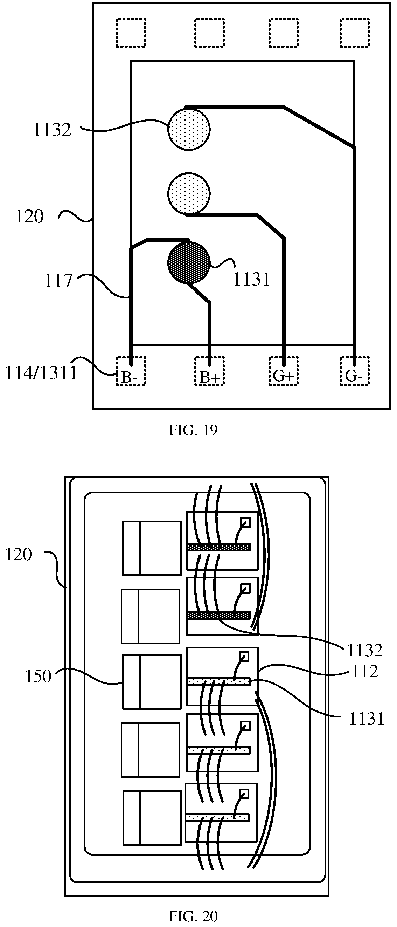

FIG. 19 is a schematic diagram illustrating an internal electrical connection relationship of a package of yet another laser device according to an embodiment of the present disclosure. Referring to FIG. 19, exemplarily, the second package 120 is provided with one first-type light emitting chip 1131 and two second-type light emitting chips 1132 therein. All of the second-type light emitting chips 1132 are connected in series as one path (not shown in FIG. 19). There is no connection between the first-type light emitting chip 1131 and the second-type light emitting chips 1132. A positive electrode and a negative electrode of the first-type light emitting chip 1131 are respectively electrically connected to bottom pads 114 at a bottom of the second package 120 via sidewall connection lines 117 within the second package 120. The bottom pads 114 are electrically connected to transfer pads 1311 of the mounting substrate 130. A positive electrode and a negative electrode of the series-connected second-type light emitting chips 1132 are respectively electrically connected to bottom pads 114 at the bottom of the second package 120 via sidewall connection lines 117 within the second package 120. The bottom pads 114 are electrically connected to transfer pads 1311 of the mounting substrate 130.

FIG. 20 is a schematic diagram illustrating an internal structure of a package of yet another laser device according to an embodiment of the present disclosure. Referring to FIG. 20, exemplarily, the second package 120 is provided with three first-type light emitting chips 1131 and two second-type light emitting chips 1132 therein. All of the first-type light emitting chips 1131 are connected in series as one path via metal wires. The three first-type light emitting chips 1131 and the two second-type light emitting chips 1132 are respectively mounted on respective heat sinks 112, and corresponding reflection components 150 are provided on the same side.

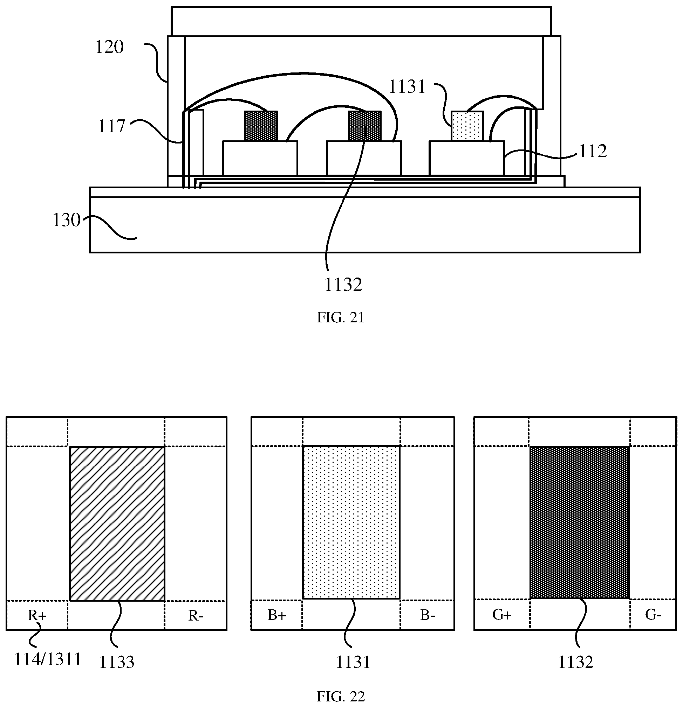

FIG. 21 is a schematic side cross-sectional structural diagram of a package of yet another laser device according to an embodiment of the present disclosure. Referring to FIG. 21, exemplarily, the second package 120 is provided with one first-type light emitting chip 1131 and two second-type light emitting chips 1132 therein, all mounted on respective corresponding heat sinks 112. All of the second-type light emitting chips 1132 are connected in series as one path via metal wires. There is no connection between the first-type light emitting chip 1131 and the second-type light emitting chips 1132. A positive electrode and a negative electrode of the first-type light emitting chip 1131 are respectively connected to the outside of the package via sidewall connection lines 117 within the second package 120. A positive electrode and a negative electrode of the series-connected second-type light emitting chips 1132 are respectively connected to the outside of the package via sidewall connection lines 117 within the second package 120.

In some possible implementations, the second package 120 is provided with at least one first-type light emitting chip 1131 and at least one second-type light emitting chip 1132 therein. All of the first-type light emitting chips 1131 are connected in series as one path, and all of the second-type light emitting chips 1132 are connected in series as one path. There is no connection between the first-type light emitting chips 1131 and the second-type light emitting chips 1132. A positive electrode and a negative electrode of the series-connected first-type light emitting chips 1131 are respectively electrically connected to bottom pads 114 at a bottom of the second package 120 via sidewall connection lines 117 within the second package 120. The bottom pads 114 are electrically connected to transfer pads 1311 of the mounting substrate 130. The transfer pads 1311 are electrically connected to corresponding transfer pads 132 via intra-board connection lines 1301. A positive electrode and a negative electrode of the series-connected second-type light emitting chips 1132 are respectively electrically connected to bottom pads 114 at the bottom of the second package 120 via sidewall connection lines 117 within the second package 120. The bottom pads 114 are electrically connected to transfer pads 1311 of the mounting substrate 130. The transfer pads 1311 are electrically connected to corresponding transfer pads 1311 via intra-board connection lines 1301, thereby achieving electrical connection between the first-type light emitting chips 1131 and the mounting substrate 130, and between the second-type light emitting chips and the mounting substrate 130. As an example, the sidewall connection lines 117 within the second package 120 are located in the sidewall 140 and the package bottom plate 116.

FIG. 22 is a schematic structural diagram of a package of yet another laser device according to an embodiment of the present disclosure. Referring to FIG. 22, exemplarily, light emitting chips of three different colors in the same light emitting unit are respectively disposed in three different packages. On a side of the package facing the mounting substrate 130, two bottom pads 114 arranged side by side are included on a side of each package close to the connection pads 132. The two bottom pads 114 below each package are respectively connected to corresponding transfer pads 1311.

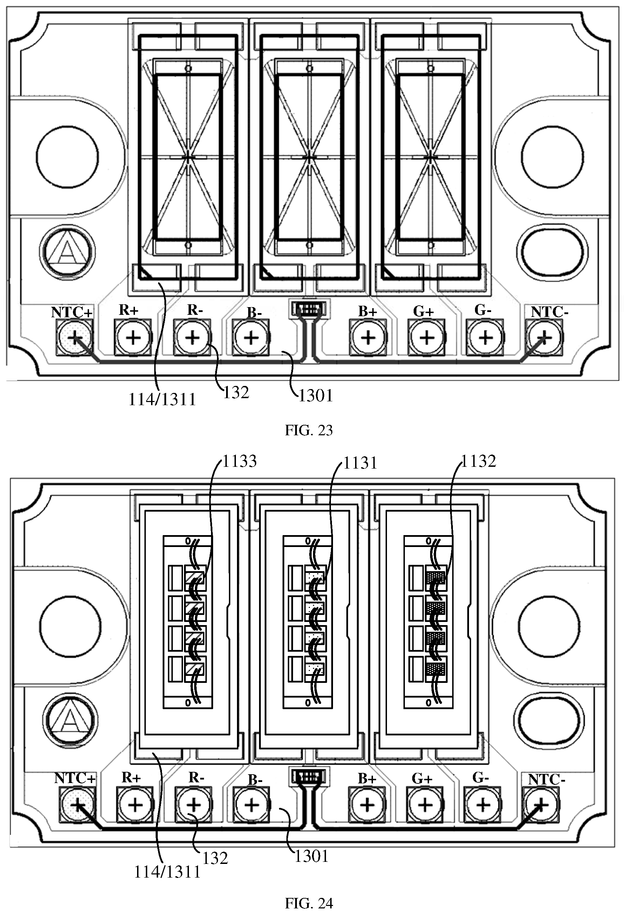

FIG. 23 is a schematic top-view structural diagram of yet another laser device according to an embodiment of the present disclosure. Referring to FIG. 22, exemplarily, light emitting chips of three different colors in the same light emitting unit are respectively disposed in three different packages, i.e., light emitting chips 113 of one color are disposed in each package, and an arrangement direction of the packages is the same as an arrangement direction of the connection pads 132. On a side of the package facing the mounting substrate 130, two bottom pads 114 arranged side by side are included on a side of each package close to the connection pads 132. The two bottom pads 114 below each package are respectively connected to a group of connection pads 132 via transfer pads 1311 and intra-board connection lines 1301. Specifically, the conductive pattern of the connection pattern of the mounting substrate 130 includes three repeating units corresponding to the packages. Each repeating unit includes two transfer pads 1311 arranged side by side on a side close to the connection pads 132. Each transfer pad 1311 is electrically connected to a corresponding connection pad 132 via an intra-board connection line 1301. The transfer pads 1311 are connected to the bottom pads 114 of the package in one-to-one correspondence. The bottom pads 114 are electrically connected to the light emitting chips 113 located within the package via sidewall connection lines 117 within the package, thereby achieving electrical connection between the light emitting chips 113 and the corresponding connection pads 132.

Exemplarily, as shown in FIG. 23, the left package is used to encapsulate red light emitting chips. The corresponding two bottom pads 114 are respectively connected to a red positive polarity pad R+ and a red negative polarity pad R- via transfer pads 1311 and intra-board connection lines 1301. The middle package is used to encapsulate blue light emitting chips. The corresponding two bottom pads 114 are respectively connected to a blue negative polarity pad B- and a blue positive polarity pad B+ via transfer pads 1311 and intra-board connection lines 1301. The right package is used to encapsulate green light emitting chips. The corresponding two bottom pads 114 are respectively connected to a green positive polarity pad G+ and a green negative polarity pad G- via transfer pads 1311 and intra-board connection lines 1301.

FIG. 24 is a schematic top-view planar structural diagram of yet another laser device according to an embodiment of the present disclosure. Referring to FIG. 24, exemplarily, the laser device includes three packages. Light emitting chips 113 of each color are individually encapsulated in one package, i.e., the light emitting chips 113 in each package have the same emission color, and the light emitting chips 113 in each package are connected in series as one path. Specifically, all of the first-type light emitting chips 1131 are disposed in the same package, and all of the first-type light emitting chips 1131 are connected in series; all of the second-type light emitting chips 1132 are disposed in the same package, and all of the second-type light emitting chips are connected in series; the third-type light emitting chips 1133 are disposed in the same package, and all of the third-type light emitting chips 1133 are connected in series. The connection pads 132 are located on a same side of the three packages, and the connection pads 132 and the packages are arranged along a same direction. Two bottom pads 114 are provided on a side of each package close to the connection pads 132. An arrangement direction of the two bottom pads 114 is the same as the arrangement direction of the connection pads 132. The two bottom pads 114 of each package are electrically connected to a corresponding group of connection pads 132.

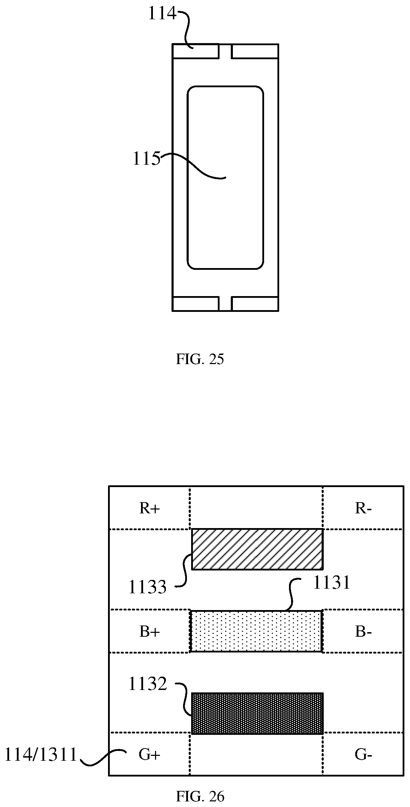

FIG. 25 is a schematic diagram illustrating a surface structure of a package of yet another laser device on a side facing a mounting substrate according to an embodiment of the present disclosure. Referring to FIG. 25, exemplarily, the conductive pattern at the bottom of each package includes four bottom pads 114 and one connection layer 115 (not connected to each other in pairs). The bottom pads 114 are located at four corners of the rectangular package, and the connection layer 115 is located at a center of the package.

In other possible implementations, bottom pads 114 may also be provided on both a side of the package close to the connection pads 132 and a side of the package away from the connection pads 132. Correspondingly, transfer pads 1311 are provided on both a side of the mounting substrate 130 close to the connection pads 132 and a side away from the connection pads 132. Under the condition that distances between the positioning holes and the packages and distances between the packages satisfy a minimum trace width, the transfer pads 1311 on the side away from the connection pads 132 can be electrically connected to the transfer pads 1311 on the side close to the connection pads 132 by providing intra-board connection lines 1301 between the positioning holes and the packages and/or between the packages, thereby increasing the trace width and thus reducing resistance.

FIG. 26 is a schematic structural diagram of a package of yet another laser device according to an embodiment of the present disclosure. Referring to FIG. 26, exemplarily, light emitting chips 113 of three colors of a single light emitting unit (i.e., the first-type light emitting chips 1131, the second-type light emitting chips 1132, and the third-type light emitting chips 1133) are encapsulated in the same package. In this package, the light emitting chips of each color are respectively connected to corresponding bottom pads, so as to be connected to corresponding connection pads on the mounting substrate.

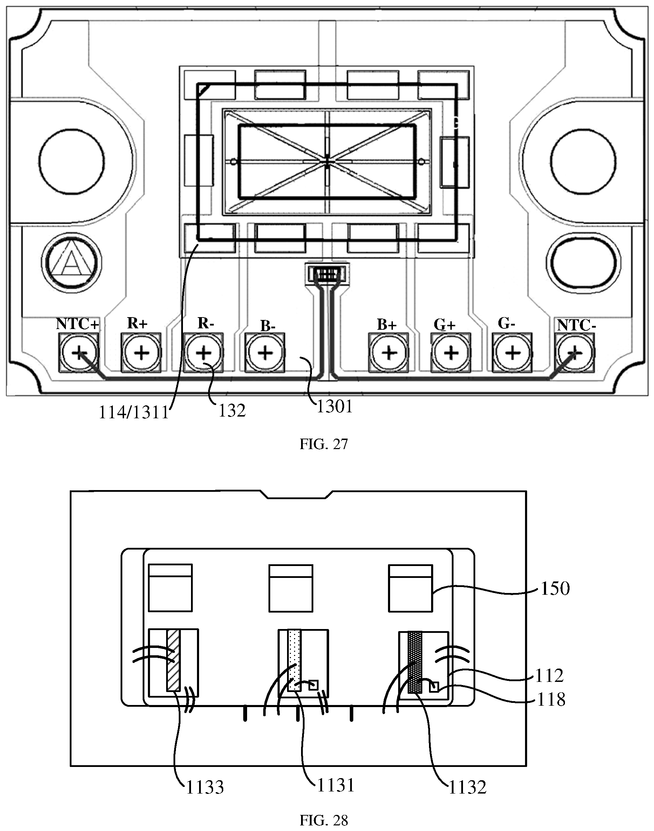

FIG. 27 is a schematic top-view structural diagram of yet another laser device according to an embodiment of the present disclosure. Referring to FIG. 27, exemplarily, in this laser device, light emitting chips 113 of three colors are disposed in one package. The package includes, at least on a first side close to the connection pads 132, four bottom pads 114 arranged side by side, and respectively includes one bottom pad 114 on a second side and a third side adjacent to the first side, the second side and the third side being opposite to each other. The six bottom pads 114 of the package are respectively connected to three groups of connection pads 132. As shown in FIG. 27, the mounting substrate 130 includes transfer pads 1311 and intra-board connection lines 1301. A side of the conductive pattern of the connection pattern close to the connection pads 132 (corresponding to the first side of the package) includes four transfer pads 1311, and left and right sides (corresponding to the second side and the third side of the package) respectively include one transfer pad 1311. These six transfer pads 1311 are connected to the six bottom pads 114 in one-to-one correspondence. The transfer pads 1311 are electrically connected to corresponding connection pads 132 via intra-board connection lines 1301, thereby achieving corresponding connection between the six bottom pads 114 and the six connection pads 132. The specific connection relationships are as follows: the bottom pad 114 on the second side (taking the left side as an example) is electrically connected to the red positive polarity pad R+ via a transfer pad 1311 and an intra-board connection line 1301; optionally, three transfer pads 1311 may be electrically connected to the red positive polarity pad R+ via the same intra-board connection line 1301; a first bottom pad 114 at a left end of the first side is electrically connected to the red negative polarity pad R- via a transfer pad 1311 and an intra-board connection line 1301; a second bottom pad 114 at the left end of the first side is electrically connected to the blue negative polarity pad B- via a transfer pad 1311 and an intra-board connection line 1301; a second bottom pad 114 at a right end of the first side is electrically connected to the blue positive polarity pad B+ via a transfer pad 1311 and an intra-board connection line 1301; a first bottom pad 114 at the right end of the first side is electrically connected to the green positive polarity pad G+ via a transfer pad 1311 and an intra-board connection line 1301; the bottom pad 114 on the third side (taking the right side as an example) is electrically connected to the green negative polarity pad G- via a transfer pad 1311 and an intra-board connection line 1301; optionally, three transfer pads 1311 may be electrically connected to the green negative polarity pad G- via the same intra-board connection line 1301.

FIG. 28 is a schematic top-view planar structural diagram of a package of yet another laser device according to an embodiment of the present disclosure. Referring to FIG. 28, exemplarily, the first-type light emitting chips 1131, the second-type light emitting chips 1132, and the third-type light emitting chips 1133 are located in the same package. The light emitting chips 113 of three colors are arranged in a line from left to right, and are respectively connected to the sidewall of the package via metal wires made of gold (Au), and are electrically connected to the sidewall connection lines. For the case where the third-type light emitting chips 1133 are red light emitting chips, the first-type light emitting chips 1131 are blue light emitting chips, and the second-type light emitting chips 1132 are green light emitting chips, the blue light emitting chips and the green light emitting chips require an anti-static device 118, while the red light emitting chips have stronger anti-static capability and therefore are not equipped with the anti-static device 118. The laser device further includes reflection components 150 and heat sinks 112. The light emitting chips 113 and the anti-static device 118 are disposed above the heat sinks 112. The reflection components 150 are located on a light output side of the light emitting chips 113, and reflecting surfaces of the reflection components 150 are aligned and matched with the light emitting chips 113. The light emitting chips 113 may be disposed in one-to-one correspondence with the heat sinks 112, or a plurality of light emitting chips 113 of the same emission color may be disposed on the same heat sink 112, which is not limited herein.

In other possible implementations, the red positive polarity pad R+ may also be connected to three adjacent transfer pads 1311 via an intra-board connection line 1301; similarly, the green negative polarity pad G- may be connected to three adjacent transfer pads 1311 via an intra-board connection line 1301, which may be configured according to relative positions and sizes of the mounting substrate 130, the packages, and the positioning holes 135, and is not limited herein.

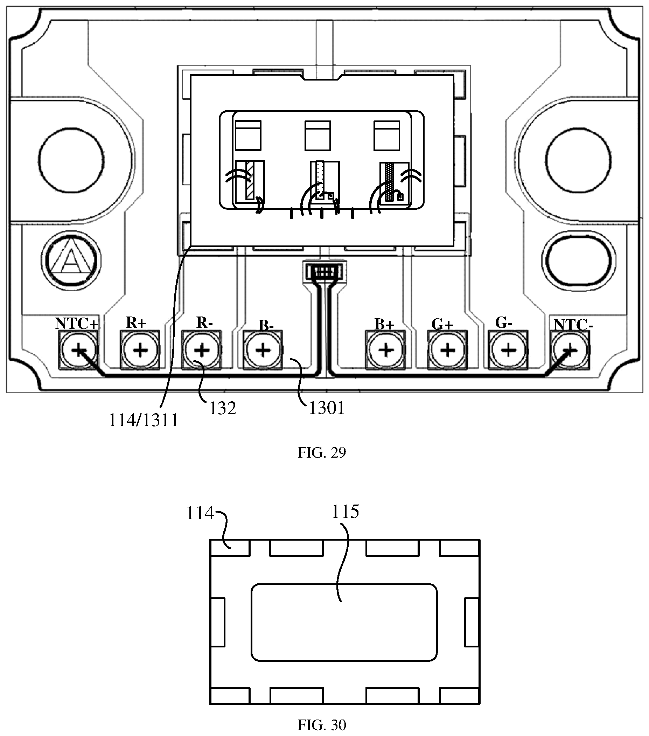

FIG. 29 is a schematic top-view planar structural diagram of yet another laser device according to an embodiment of the present disclosure. Referring to FIG. 29, exemplarily, a side of the package close to the connection pads 132 is a first side, a second side and a third side are respectively located on left and right sides and are adjacent to the first side; four bottom pads 114 are arranged side by side on the first side of the package, one bottom pad 114 is provided on the second side, and one bottom pad 114 is provided on the third side.

As shown in FIG. 29, the mounting substrate 130 includes transfer pads 1311 and intra-board connection lines 1301. A side of the conductive pattern of the connection pattern close to the connection pads 132 (corresponding to the first side of the package) includes four transfer pads 1311, and left and right sides (corresponding to the second side and the third side of the package) respectively include one transfer pad 1311. These six transfer pads 1311 are connected to the six bottom pads 114 in one-to-one correspondence. The transfer pads 1311 are electrically connected to corresponding connection pads 132 via intra-board connection lines 1301, thereby achieving corresponding connection between the six bottom pads 114 and the six connection pads 132. The specific connection relationships are as follows: the bottom pad 114 on the second side (taking the left side as an example) is electrically connected to the red positive polarity pad R+ via a transfer pad 1311 and an intra-board connection line 1301; optionally, three transfer pads 1311 may be electrically connected to the red positive polarity pad R+ via the same intra-board connection line 1301; a first bottom pad 114 at a left end of the first side is electrically connected to the red negative polarity pad R- via a transfer pad 1311 and an intra-board connection line 1301; a second bottom pad 114 at the left end of the first side is electrically connected to the blue negative polarity pad B- via a transfer pad 1311 and an intra-board connection line 1301; a second bottom pad 114 at a right end of the first side is electrically connected to the blue positive polarity pad B+ via a transfer pad 1311 and an intra-board connection line 1301; a first bottom pad 114 at the right end of the first side is electrically connected to the green positive polarity pad G+ via a transfer pad 1311 and an intra-board connection line 1301; the bottom pad 114 on the third side (taking the right side as an example) is electrically connected to the green negative polarity pad G- via a transfer pad 1311 and an intra-board connection line 1301; optionally, three transfer pads 1311 may also be electrically connected to the green negative polarity pad G- via the same intra-board connection line 1301.

In other possible implementations, the red positive polarity pad R+ may also be connected to three adjacent transfer pads 1311 via an intra-board connection line 1301; similarly, the green negative polarity pad G- may be connected to three adjacent transfer pads 1311 via an intra-board connection line 1301, which may be configured according to relative positions and sizes of the mounting substrate 130, the packages, and the positioning holes 135, and is not limited herein.

In some possible implementations, as shown in FIG. 29 and FIG. 30, the package further includes a fourth side opposite to the first side, and includes four bottom pads 114 arranged side by side on the fourth side; two of the bottom pads 114 on the fourth side are connected together via the same intra-board connection line 1301, and the other two bottom pads 114 are connected together via the same intra-board connection line 1301.

In this embodiment, the fourth side of the package is the side away from the connection pads 132, and four bottom pads 114 are also provided on this side. Correspondingly, as shown in FIG. 27, four transfer pads 1311 are also provided on a side of the connection pattern 13 away from the connection pads 132, and the four transfer pads 1311 are connected to the four bottom pads on the fourth side of the package in one-to-one correspondence; the two left transfer pads 1311 are electrically connected to a transfer pad 1311 located on a left side of the connection pattern 13 nearby, so that these three transfer pads 1311 are electrically connected to the red positive polarity pad R+ via the same intra-board connection line 1301, thereby achieving that the two bottom pads 114 on the fourth side of the package are connected to the bottom pad 114 on the second side via the same intra-board connection line 1301; the two right transfer pads 1311 are connected to a transfer pad 1311 located on a right side of the connection pattern 13 nearby, so that these three transfer pads 1311 are electrically connected to the green negative polarity pad G- via the same intra-board connection line 1301. With such an arrangement, both the red positive polarity pad R+ and the green negative polarity pad G- are connected to three transfer pads 1311, thereby achieving that the two bottom pads 114 on the fourth side of the package are connected to the bottom pad 114 on the third side via the same intra-board connection line 1301. Such an arrangement increases the width of the intra-board connection lines 1301, which is beneficial for reducing resistance.

It should be noted that FIG. 27 and FIG. 29 only exemplarily show that the transfer pads 1311 on the side of the mounting substrate 130 away from the connection pads 132 are divided into two groups, each group having two transfer pads 1311, but this does not constitute a limitation on the laser device provided in the embodiments of the present disclosure.

FIG. 30 is a schematic diagram illustrating a surface structure of a package of yet another laser device on a side facing a mounting substrate according to an embodiment of the present disclosure. Referring to FIG. 30, exemplarily, the conductive pattern at the bottom of the package includes eight bottom pads 114 and one connection layer 115 (not connected to each other in pairs). The eight bottom pads 114 are located around the rectangular package (four bottom pads 114 are provided on the first side, one bottom pad 114 is respectively provided on the second side and the third side, and four bottom pads 114 are provided on the fourth side). The connection layer 115 is located at a center of the package.

In some possible implementations, within a plane where the mounting substrate 130 is located, a length of the connection pads 132 in an arrangement direction of the connection pads 132 is between 1.3 mm and 1.7 mm; along the arrangement direction of the connection pads 132, a spacing between adjacent connection pads 132 is between 0.8 mm and 1.2 mm.

In some possible implementations, within the plane where the mounting substrate 130 is located, a long side length of the transfer pads 1311 is between 1.1 mm and 1.5 mm, and a short side length is between 0.4 mm and 0.8 mm; along an arrangement direction of the transfer pads 1311, a spacing between adjacent transfer pads 1311 is between 0.1 mm and 0.5 mm.

The present disclosure does not limit the dimensions (including length and width) of the package, and the dimensions of the package may be set according to requirements of the laser device. For example, a dimension of the package is 10.6 mm × 6.4 mm.

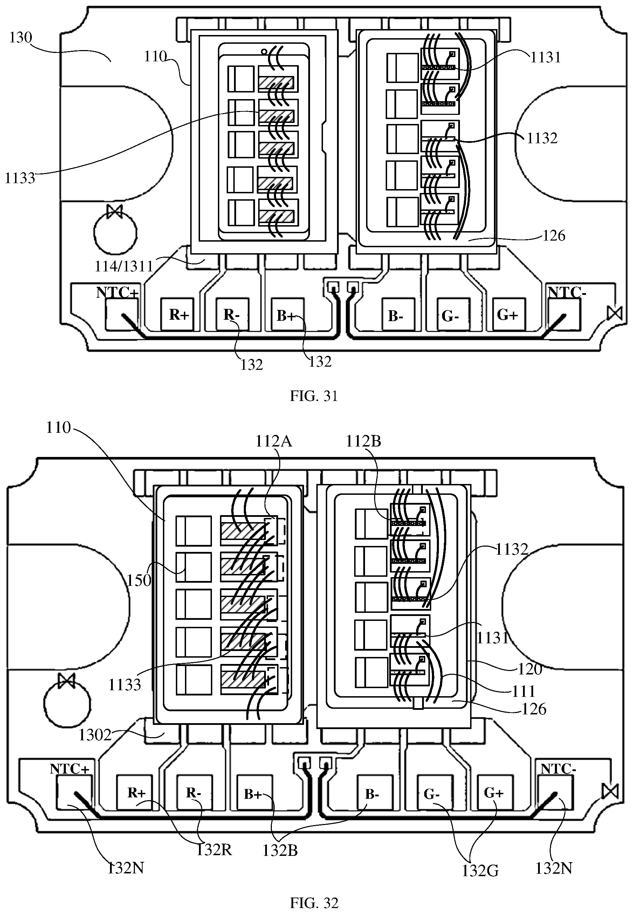

FIG. 31 is a schematic top-view planar structural diagram of yet another laser device according to an embodiment of the present disclosure. Different from the example of FIG. 11, the arrangement positions of the first-type light emitting chips 1131, the second-type light emitting chips 1132, and the third-type light emitting chips 1133 in the packages shown in FIG. 31 are different. In FIG. 31, two light emitting chips connected in series at an upper portion are first-type light emitting chips 1131, i.e., blue light emitting chips, and three light emitting chips connected in series at a lower portion are second-type light emitting chips 1132, i.e., green light emitting chips. Furthermore, in this example, the third-type light emitting chips 1133 are mounted on a lower side of the corresponding heat sinks (i.e., a side close to a group of connection pads 132 corresponding to the third-type light emitting chips 1133), and metal wires corresponding to the third-type light emitting chips 1133 extend to an upper side of the heat sinks as shown in the figure. Thus, the third-type light emitting chips 1133 and the corresponding metal wires are arranged side by side along a length direction of the heat sinks, and are respectively located in different regions along a width direction of the heat sinks. In this case, the heat sinks corresponding to the third-type light emitting chips 1133 have a long strip shape. By arranging the light emitting chips and the corresponding metal wires on opposite side regions of the long strip-shaped heat sinks, on one hand, heat conduction can be ensured by the area variation of the long strip-shaped heat sinks, and on the other hand, a dimension in the width direction of the heat sinks can be reduced, thereby allowing more light emitting chips to be disposed within the limited internal space of the package. Another difference between FIG. 11 and FIG. 31 is that the metal wires for light emitting chips of different colors in the second package are different, the corresponding transfer pads 1311 on the mounting substrate 130 are different, and the intra-board connection lines 1301 connected via the transfer pads 1311 on the mounting substrate 130 are also different.

In some examples, as shown in FIG. 11 and FIG. 31, the number of temperature detection components NTC (e.g., the thermistor 134) may be one, disposed on the mounting substrate 130 and located between the first package and the second package, for measuring a temperature rise in a region between the two packages, so as to reflect temperature rise data of the light emitting chips in the two packages.

In some implementations, two electrodes of the temperature detection component and a plurality of electrodes of the light emitting chips are disposed at one location, and are respectively located on two sides of the plurality of electrodes of the plurality of light emitting chips. As shown in FIG. 11, the temperature detection component NTC is also provided with corresponding connection pads 132d on the mounting substrate 130, and there are two connection pads 132d, respectively located on two sides of the connection pads corresponding to the plurality of light emitting chips. In this way, a trace path of the temperature detection component is longer, but trace path lengths of different light emitting chips can be shortened, thereby improving power supply reliability.

FIG. 32 is a schematic top-view planar structural diagram of yet another laser device according to an embodiment of the present disclosure. In some embodiments, referring to FIG. 32, the laser device 10 includes a first package 110 and a second package 120. For relevant descriptions of constituent structures of the first package 110 and the second package 120, and electrical connections with the mounting substrate, reference may be made to the relevant description of the laser device corresponding to FIG. 11. Furthermore, the electrical connection relationship between the second package 120 and the mounting substrate in the example of FIG. 32 may also refer to the relevant description in the example of FIG. 4, which is not repeated. Compared with the laser device illustrated in FIG. 11, in the example of FIG. 32, a connection manner between metal wires of a plurality of red light emitting chips in the second package 120 and the heat sinks is different from that in the example of FIG. 4.

Referring to FIG. 32, the second package 120 includes first-type light emitting chips 1131 and second-type light emitting chips 1132. During series connection of the plurality of first-type light emitting chips 1131 and the plurality of second-type light emitting chips 1132 respectively, one light emitting chip is connected to a side portion of a heat sink of an adjacent light emitting chip via a metal wire, such as a heat sink side portion region 112B shown in FIG. 32. This connection manner requires sufficient space in a width direction of the heat sink, so that a wire bonding position is reserved in the side portion region of the heat sink, allowing metal wires of adjacent light emitting chips to be connected thereto. This connection manner provided in this example can provide a better heat conduction radiation path for the light emitting chips, because generally, the wider the heat sink, the longer the heat conduction path outward to two sides of the light emitting chip, but this usually leads to an increase in a dimension in a length direction of the package.

For the first package 110, it includes a plurality of third-type light emitting chips, and all of the third-type light emitting chips are connected in series. Different from the second package 120, a metal wire of one third-type light emitting chip is connected to a rear end of a heat sink 112 of an adjacent third-type light emitting chip, such as a heat sink rear end region 112A shown in FIG. 32. It should be noted that a front end and a rear end of the heat sink are defined relative to a light output end face of the light emitting chip, or relative to a disposition position of the reflection component 150. On the heat sink, a region of the heat sink close to the light output end face of the light emitting chip 113, or a region of the heat sink close to the reflection component 150, is called the front end of the heat sink; while on the heat sink, a region of the heat sink away from the light output end face of the light emitting chip, or a region of the heat sink away from the reflection component, is called the rear end of the heat sink. In the connection manner provided in this example, the heat sink has a slender strip shape, i.e., a narrower width direction compared to the heat sink in the first package 110 in the example of FIG. 32. By providing the slender strip-shaped heat sink, a certain heat sink heat conduction area can be provided, and when arranging the same number of light emitting chips, a dimension along an arrangement direction of the light emitting chips, i.e., the length direction of the package, can be correspondingly reduced. In some examples, reducing the dimension in the length direction of the package may only slightly increase or even not increase the dimension in the width direction of the package. Furthermore, in some examples, the slender strip-shaped heat sink structure can also ensure a reasonable spacing between light emitting chips without changing the package dimensions, thereby arranging more light emitting chips in a limited space.

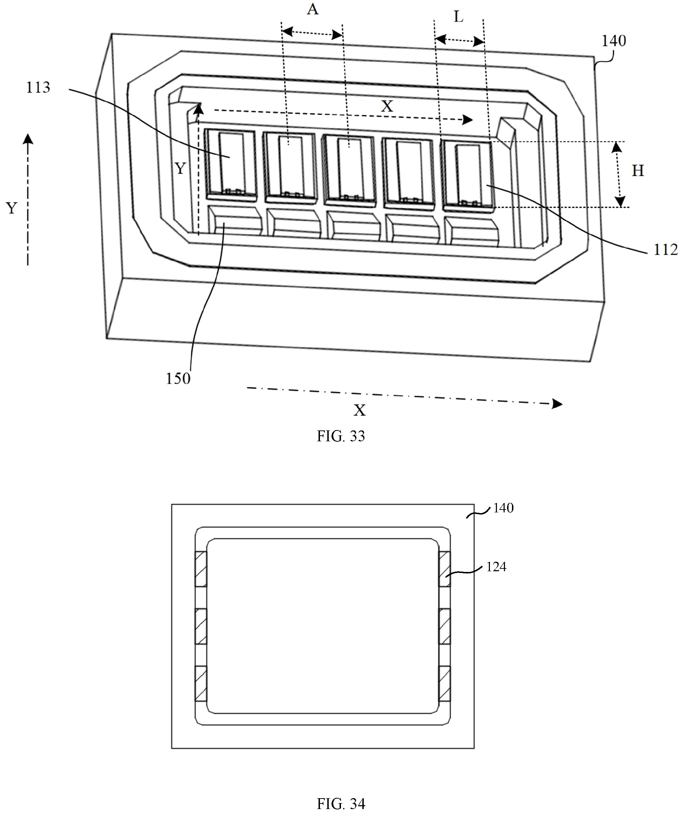

FIG. 33 is a schematic diagram illustrating an internal structure of a package in a laser device according to an embodiment of the present disclosure. Referring to FIG. 33, for better illustration: H represents a width of the heat sink 112, and L represents a length of the heat sink 112. A is a spacing between central axes of two light emitting chips, which may also be regarded as a spacing between two light emitting chips.

In this example, an outer contour of the sidewall 140 of the package is rectangular. In some examples, a dimension in a length direction of the package is about 8.5 mm to 9.0 mm, a dimension in a width direction is 5.9 mm to 6.9 mm, and a wall thickness of the package is about 1 mm.

The sidewall 140 of the package has a certain thickness. A projected shape of an inner space of the sidewall 140 of the package is also approximately rectangular, hereinafter referred to as an inner rectangle. A length of a long side of the inner rectangle is about 5.5 mm, and a length of a short side is about 3.5 mm to 4.5 mm. The inner rectangle and the outer rectangular contour of the package are roughly similar in shape.

Along the length direction of the sidewall 140 of the package, or the length direction of the inner rectangle of the package, i.e., the X direction shown in FIG. 33, a plurality of heat sinks 112 are arranged in a row, and there is a gap between two adjacent heat sinks 112.

In some examples, a spacing between the plurality of heat sinks is between 1.0 mm and 1.25 mm. Taking one of the heat sinks as an example for illustration, a width H of the heat sink is between 0.85 mm and 0.95 mm.

The width of the heat sink 112 is related to a size of the light emitting chip 113 itself and processing technology requirements. In some specific examples, a width of the light emitting chip 113 above the heat sink 112 is about 500 µm, and a width of an AuSn solder layer for soldering the light emitting chip and the heat sink is about 550 µm to 600 µm. In some examples, a Zener diode may also be provided on the heat sink as the above-mentioned anti-static device, and the Zener diode is arranged side by side with the light emitting chip. Therefore, the width of the heat sink 112 is at least greater than the widths of the light emitting chip and the Zener diode.

According to the foregoing description, a reflection component 150 is further provided in front of the light emitting chip 113. The light emitting chip 113 and the reflection component 150 are arranged along the width direction of the package, or along the short side direction of the inner rectangle of the package.

The length direction of the heat sink 112 is parallel to the width direction of the sidewall 140 of the package or the short side direction of the inner rectangle of the package (the Y direction in the figure).

In some examples, a ratio of the length to the width of the heat sink 112 is set between 1 and 3.5.

In some embodiments, a ratio of the length to the width of the heat sink 112 is between 1.5 and 3.5. In a specific implementation, L=2.1 mm, H=0.65 mm, then the ratio of the length to the width of the heat sink 112 is 3.2. The heat sink has a slender strip shape, which can be applicable to a situation without a Zener diode, such as for red light emitting chips, or applicable to a situation where the Zener diode and the light emitting chip are arranged along the length direction of the heat sink. Through the above arrangement, under the premise of the same internal space of the package and a given spacing, the smaller the width of the heat sink, the more corresponding light emitting chips can be arranged, thereby the higher the density of the light emitting chips, the higher the accommodation rate of light emitting elements in the package, and the higher the optical power. However, the higher the arrangement density of the light emitting chips, the higher the requirement for heat dissipation. Therefore, in the above situation, the heat sink may adopt a material with a higher thermal conductivity, such as diamond copper. Alternatively, consider an integrated arrangement of the package bottom plate and the heat sink, using the same material to alleviate the thermal resistance problem caused by joining different materials.

In another specific implementation, L=1.7 mm, H=1.1 mm, the ratio of the length to the width of the heat sink 112 is 1.5, then the shape of the heat sink is approximately square, which is conducive to arranging the Zener diode and the light emitting chip side by side. Furthermore, since heat conduction of the light emitting chip is in multiple directions downward and outward, when the shape of the heat sink is closer to a centrally symmetric figure, the heat conduction of the light emitting chip is better balanced in all directions. For example, in the above example, the dimensions in the long side direction and the short side direction of the heat sink are comparable, such as a square, or the shape of the heat sink is circular, or the shape of the heat sink is polygonal. In this example, in order to increase the arrangement density of the light emitting chips, when the width of the heat sink is larger than that in the previous example, consideration may be given to reducing the spacing between adjacent heat sinks. For example, in this example, the spacing between heat sinks may be 1.0 mm, which can also increase the number of light emitting chips accommodated under the same internal space condition of the package.

Through the above embodiments, a high-power laser light emitting assembly can be provided.

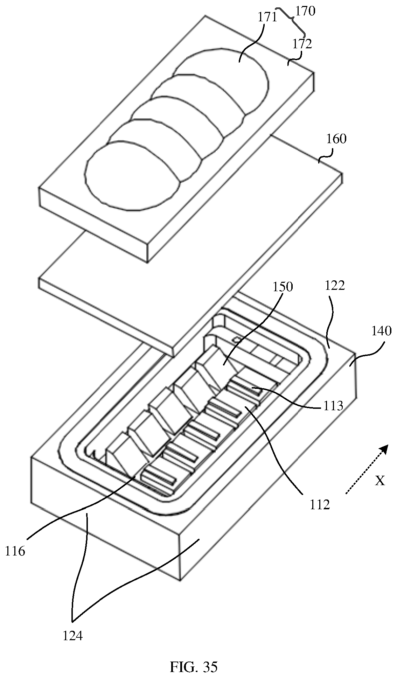

FIG. 34 is a schematic cross-sectional structural diagram of a package in a laser device according to an embodiment of the present disclosure; FIG. 35 is a schematic exploded structural diagram of a package in a laser device according to an embodiment of the present disclosure.

As shown in FIG. 35, the laser device 10 further includes a lens assembly 170 and reflection components 150. The sidewall 140 of the package is annular and surrounds the plurality of heat sinks 112, the plurality of light emitting chips 113, and the plurality of reflection components 150. The lens assembly 170 is located on a side of the sidewall 140 of the package away from the mounting substrate 130. An upper portion of the sidewall 140 of the package is connected to the light transmitting component 160 to form a sealed space.

The plurality of light emitting chips 113 are in one-to-one correspondence with the plurality of reflection components 150. Each reflection component 150 is located on a light output side of the corresponding light emitting chip 113. The reflection component 150 is used to reflect light emitted from the corresponding light emitting chip 113 to the lens assembly 170 corresponding to the light emitting chip 113, and then the lens assembly 170 collimates the light. The reflection component 150 may specifically be a reflection prism, or a reflection mirror having a support structure. A reflection point position of one reflection component 150 corresponds to a center of a corresponding collimating lens in the lens assembly 170. In this example, the plurality of light emitting chips 113 are in one-to-one correspondence with the plurality of reflection components 150, and the plurality of reflection components 150 are in one-to-one correspondence with the plurality of collimating lens units in the lens assembly 170. Therefore, the number of light emitting chips 113 is the same as the number of reflection components 150 and the number of collimating lens units in the lens assembly 170.

Some embodiments of the package are introduced below with reference to the accompanying drawings.

FIG. 34 is a cross-sectional view looking down from above at the package. As shown in FIG. 33, the sidewall 140 of the package has a thickness, and a plurality of conductive regions 124 are formed inside the package.

Referring to FIG. 4 and FIG. 5, a plurality of packages are disposed on the mounting substrate 130.

Referring to FIG. 6, for each package, a light emitting assembly composed of heat sinks and light emitting chips, the lens assembly 170, and the reflection components 150 are disposed in an accommodating space. The package has a certain height, and the package is respectively connected to the package bottom plate and the light transmitting component to form the above accommodating space.

In a specific implementation, referring to FIG. 35, the sidewall 140 of the package has an upper surface 122 and a plurality of outer side surfaces. In a top view, an outer contour shape of the sidewall 140 of the package is rectangular, and an inner contour shape of the sidewall 140 of the package is also rectangular.

In some embodiments, the sidewall 140 of the package is made of a ceramic material. Furthermore, the sidewall 140 of the package is not limited to ceramic, and may also be formed using metal or a composite containing metal as a main material. For example, among ceramics, aluminum nitride, silicon nitride, alumina, and silicon carbide can be used as the main material of the sidewall 140 of the package.

The sidewall 140 of the package may also be made of a metal material, such as composites of copper, aluminum, iron, and copper-molybdenum, copper-diamond composite material, copper-tungsten, etc., used as the main material of the sidewall 140 of the package.

Here, the main material refers to a material accounting for the largest proportion by mass or volume in the formed object.

In this example, the sidewall 140 of the package is made of a ceramic material. As shown in FIG. 6, a conductive region is formed in an inner wall of the sidewall 140 of the package, and the light emitting chips 113 are electrically connected to the conductive region 124 of the sidewall 140 of the package.

In other embodiments, the material of the sidewall 140 of the package may include one or more of oxygen-free copper and ceramic materials. When the mounting substrate 130 is a PCB board including oxygen-free copper therein, since the thermal conductivity of oxygen-free copper is also relatively high, the mounting substrate 130 can assist the heat sinks 112 in conducting heat generated by the light emitting chips 113.

In some implementations, the plurality of light emitting chips 113 are at least five in number, and the plurality of light emitting chips 113 are arranged within the sidewall 140 of the package along a first direction, wherein the first direction is a length direction of the sidewall 140 of the package.

It should be noted that such an arrangement not only achieves miniaturization of the device, but also improves thermal management efficiency, optimizes circuit design and layout, reduces production costs, and enhances the performance and reliability of the device.

The first direction may be the length direction of the sidewall 140 of the package, and the plurality of light emitting chips 113 may be arranged at intervals along the length direction of the sidewall 140 of the package.

As shown in FIG. 35, X represents the first direction, i.e., the length direction of the sidewall 140 of the package.

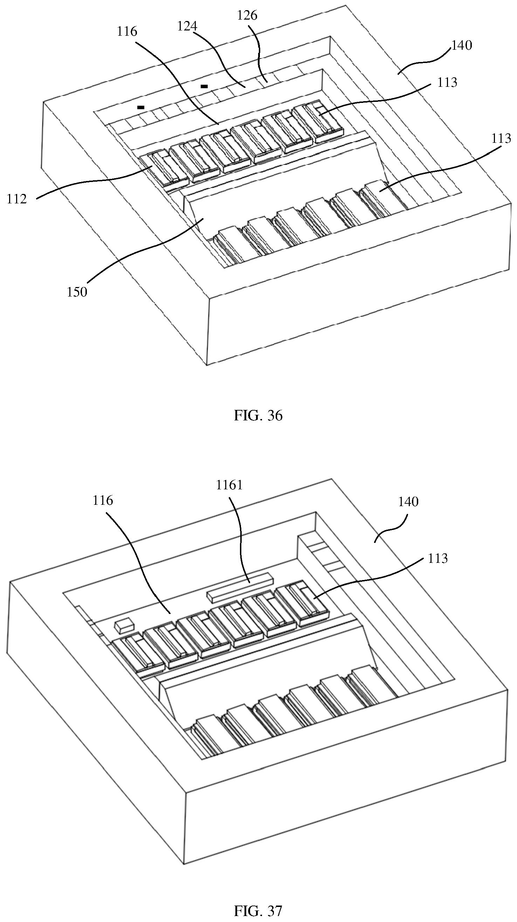

FIG. 36 is a schematic diagram illustrating an internal structure of another package in the laser device according to an embodiment of the present disclosure.

As shown in FIG. 36, the sidewall 140 of the package is provided with a step portion 126. Conductive regions 124 are provided on the step portion 126. The plurality of conductive regions 124 are located on a partial surface area of the step portion 126, and are isolated and not communicated with each other via insulating regions. The conductive regions 124 are used to connect the light emitting chips 113 and the conductive traces within the sidewall 140 of the package.

In some embodiments, the sidewall 140 of the package has one or more step portions 126, and the conductive regions 124 are provided on the one or more step portions 126.

As shown in FIG. 36, the step portion 126 may be formed around an inner peripheral sidewall of the sidewall 140 of the package and protrude inward of the sidewall 140 of the package. The step portion 126 may also be located only on one inner sidewall of the package, or on two opposite inner sidewalls, or on two adjacent inner sidewalls.

FIG. 37 is a schematic diagram illustrating an internal structure of yet another package in the laser device according to an embodiment of the present disclosure.

As shown in FIG. 37, a transfer stage 1161 is further provided. The transfer stage 1161 is located on the package bottom plate 116 between the sidewall 140 of the package and the light emitting chips 113. The transfer stage 1161 has a conductive region thereon for connecting metal wires of the light emitting chips 113 and the conductive trace region within the sidewall 140 of the package.

Through the transfer of the transfer stage 1161, the occurrence of breakage problems of the metal wires of the light emitting chips can be reduced, and the difficulty of wire bonding can be lowered. The metal wires of the light emitting chips may be first connected to the transfer pad, and then through the communication between the transfer pad and the conductive region within the package wall, the communication between the light emitting chips and the conductive region of the package is achieved.

In some embodiments, there may be a plurality of transfer stages 1161, thereby providing transfer paths for a plurality of metal wires and reducing the difficulty of wire bonding.

Below, with reference to the accompanying drawings, a red light emitting chip is taken as an example for introduction.

In this example, a ratio of the length to the width of the heat sink 112 corresponding to the red light emitting chip is between 1 and 1.7.

When the light emitting chip 113 is a red light emitting chip, heat transfer from the light emitting chip 113 starts from an edge angle and propagates downward at an angle θ, i.e., θ is a heat conduction angle from the light emitting chip toward the heat sink. Then, a width L of the heat sink satisfies L ≥ (L0 + 2 tanθ * D), where L0 is a width of the light emitting chip, and D is a layer thickness of the heat sink. The layer thickness of the heat sink 112 is generally about 300 µm, and the width of the light emitting chip 113 is about 0.5 mm. When heat radiation or heat transfer is performed at an angle of 45°, the width L of the heat sink is about 1.1 mm. The above arrangement can better perform rapid heat conduction for the heat generated during the light emitting process of the light emitting chip, thereby alleviating heat accumulation.

Furthermore, in this example, a length H of the heat sink satisfies H = Ho * K1 + K2, where Ho is a length of the light emitting chip, taking a value of 1.2 mm to 1.5 mm, K1 is an accommodation coefficient, with a value range of 1.06 to 1.12; K2 is a constant, with a value range of 0.05 to 0.1. In a specific implementation, Ho = 1.5 mm, K1 = 1.067, K2 = 0.05 mm, then the length H of the heat sink is 1.65 mm.

In some implementations, a ratio of a width of one heat sink 112 to a width of the sidewall 140 of the package is between 0.05 and 0.2. It should be noted that the width of the package here refers to a short side length of the outer rectangular contour of the package.

A ratio of a sum of widths of all heat sinks 112 to the width of the sidewall 140 of the package is between 0.4 and 0.8.

Through the above arrangement, the accommodation rate of the heat sinks 112 in the internal space of the sidewall 140 of the package can be improved, thereby facilitating the arrangement of more light emitting chips.

Moreover, since the thermal conduction performance of the heat sink is generally superior to that of the package bottom plate and the package, increasing the accommodation rate of the heat sinks in the package is also beneficial for accelerating heat conduction within the limited package space.

In some specific implementations, the width of the heat sink 112 is 1.05 mm, the width of the sidewall 140 of the package is 8.5 mm, and the ratio of the width of the heat sink 112 to the width of the sidewall 140 of the package is 0.12.

In other specific implementations, the width of the heat sink 112 is 0.8 mm, and the ratio of the width of the heat sink 112 to the width of the sidewall 140 of the package is 0.09.

Furthermore, the total width of the heat sinks 112 may be limited according to the actual number of light emitting chips 113 mounted.

In some specific implementations, a ratio of a width of one heat sink 112 to a width of the sidewall 140 of the package is between 0.07 and 0.12.

In some specific implementations, a ratio of a width of one heat sink 112 to a width of the sidewall 140 of the package is between 0.1 and 0.15.

In some examples, the width of the sidewall 140 of the package is 8.5 mm, and when the width of the heat sink 112 is between 0.6 mm and 1 mm, five light emitting chips 113 can be mounted. At this time, a ratio of a width of one heat sink 112 to the width of the sidewall 140 of the package is between 0.07 and 0.12.

Theoretically, increasing the width of the heat sink 112 and correspondingly increasing the width of the sidewall 140 of the package is also a solution. This can be beneficial for the heat dissipation effect of the light emitting chips, but it will enlarge the package, thereby also increasing the size of the light emitting unit. For the case of five light emitting chips, increasing the width of the heat sink 112 and enlarging the arrangement size can achieve a better heat dissipation effect. For example, if the width of the heat sink 112 is 1.3 mm, the sidewall 140 of the package needs to be correspondingly increased to about 10 mm to arrange five light emitting chips. At this time, a ratio of a width of one heat sink 112 to the width of the sidewall 140 of the package is between 0.1 and 0.15.

As shown in FIG. 33, A represents a spacing between light emitting points of two adjacent light emitting chips 113. In some specific implementations, a ratio of the spacing between light emitting points of two adjacent light emitting chips 113 to the width of the sidewall 140 of the package is between 0.08 and 0.2.

The light emitting point spacing consists of two parts: one part is the size of the heat sink 112, and the other part is the spacing between two heat sinks 112. The width range of the heat sink 112 can be 0.8 mm to 1.3 mm, where a larger size is more favorable for heat dissipation. From considerations of process and design miniaturization, the spacing between two heat sinks 112 can be between 0.1 mm and 0.2 mm, and of course, it can also be larger, but this is not conducive to miniaturization.

Based on this, the value of A in FIG. 33 can be between 0.9 mm and 1.5 mm. A ratio of the light emitting point spacing A to the width of the sidewall 140 of the package can be between 0.08 and 0.2. Within this range, arrangement of different numbers of light emitting chips 113 can be ensured, which helps to realize a miniaturized and integrated laser device.

Furthermore, some embodiments regarding the reflection component 150 are introduced with reference to the accompanying drawings.

As shown in FIG. 35, the laser device includes a plurality of reflection components 150. In some examples, a distance between two adjacent reflection components 150 is between 0.35 mm and 0.45 mm.

The reflection component 150 is disposed on the package bottom plate 116, for example, fixed by adhesion. The reflection component 150 may be a reflection prism or a reflection mirror. In some embodiments, the plurality of reflection components 150 are respectively configured in correspondence with the plurality of light emitting chips 113. When a plurality of light emitting chips are disposed in the package and the plurality of light emitting chips are arranged in a row, a distance between an emission end face of each group of light emitting chips 113 and the corresponding reflection component 150 is usually set to be the same, so that positions of reflection light emitting points on the plurality of reflection components 150 are consistent along an arrangement direction of the light emitting chips, and finally correspond relatively well to the integrally formed lens assembly 170, specifically corresponding to center positions of the plurality of integrally formed collimating lenses for emission.

Of course, in some implementations, due to differences in light output characteristics of the light emitting chips, the distance between the reflection component 150 and the corresponding light emitting surface of the light emitting chip can be adjusted, thereby improving the positional consistency of the light emitting points on the reflection surface.

Furthermore, in some embodiments, one reflection component 150 may also be configured in correspondence with a plurality of light emitting chips 113. In this case, the reflection component 150 may be elongated and have at least one reflection surface.

The reflection component 150 has a lower surface and a light reflection surface for reflecting light. In addition, the light reflection surface is inclined relative to the lower surface. That is, regarding the light reflection surface, a configuration relationship observed from the lower surface is neither vertical nor parallel. A straight line connecting a lower end and an upper end of the light reflection surface is inclined relative to the lower surface of the reflection component 150. An angle of the light reflection surface relative to the lower surface, or an angle of the straight line connecting the lower end and the upper end of the light reflection surface relative to the lower surface, is referred to as an inclination angle of the light reflection surface.

In the illustrated reflection component 150, the light reflection surface is a plane and forms an inclination angle of 45 degrees relative to the lower surface of the reflection component 150. It should be noted that the light reflection surface may not be a plane, for example, it may be a curved surface. In addition, the inclination angle of the light reflection surface may not be 45 degrees.

The light reflection surface of the reflection component 150 is formed with a film and has a light reflection function. Main materials of the reflection component 150 include, for example, quartz or BK7 (borosilicate glass) and other glasses, metals such as aluminum, or Si. The light reflection film is a material with high light reflectivity, such as metals like Ag, Al, or dielectric multilayer films like Ta₂O₅/SiO₂, TiO₂/SiO₂, Nb₂O₅/SiO₂. In addition, when the reflection component 150 is formed using a material with high light reflectivity such as metal as the main material to form its outer shape, formation of the light reflection film may be omitted.

A main portion of light radiated from the light emitting chip 113 irradiates the light reflection surface of the corresponding reflection component 150. The light radiated from the light emitting chip 113 passes through the reflection component 150, so that compared to a case without the interposed reflection component 150, an optical path length of light incident on the lens can be lengthened. This longer optical path length can reduce the influence of mounting deviation between the reflection component 150 and the light emitting chip 113. In addition, the first package 110 may also be provided without the reflection component 150, with the emission end face of the light emitting chip 113 facing upward.

On the light reflection surface, a reflectance for a peak wavelength of light irradiated onto the light reflection surface is 90% or more. In addition, the reflectance may also be 95% or more. Furthermore, the reflectance can be set to 99% or more. The light reflectance is 100% or less, or less than 100%.

In some implementations, a spacing between the reflection component 150 and the corresponding light emitting surface of the light emitting chip is generally designed to be between 0.2 mm and 0.5 mm, with a preferred range being between 0.35 mm and 0.45 mm. This is theoretically not limited, but from perspectives of application and miniaturization, this range is preferable for a reflective system.

When the spacing between the reflection component 150 and the corresponding light emitting surface of the light emitting chip is too small, for example, less than 0.2 mm, the tolerance margin becomes small, making the process difficult to achieve. If the spacing is too large, for example, greater than 0.5 mm, since the beam emitted from the light emitting surface of the light emitting chip has a divergence angle, the spot incident on the reflection surface of the reflection component is larger, resulting in a certain loss of optical efficiency. Therefore, considering both process and efficiency, a range of 0.35 mm to 0.45 mm can combine the advantages of both aspects, achieving a miniaturized, high-efficiency system.

Some embodiments of the light transmitting component 160 are introduced below with reference to the accompanying drawings.

As shown in FIG. 6 or FIG. 35, in some optional embodiments, the laser device 10 further includes a light transmitting component 160. The light transmitting component 160 is used to be welded with the sidewall 140 of the package to form a sealed space. The light transmitting component 160 may have light transmissivity as a whole, or may have light transmissivity only with respect to a portion of the light output region, such as a central region, while a partial region, such as a peripheral region near the welding area with the package, may be provided with a light shielding film and does not have light transmissivity.

The light transmitting component 160 is usually formed using glass as a main material, but is not limited to glass. For example, sapphire may also be used as a main material for formation.

The light transmitting component 160 is joined at its lower surface to the upper surface 122 of the sidewall 140 of the package (package upper surface 122). A metal film is provided in a joining region between the light transmitting component 160 and the sidewall 140 of the package, and is fixed via AuSn solder. The second package 120 is joined with the light transmitting component 160 via the sidewall 140 of the package to form a closed space. This closed space is a hermetically sealed space. By performing hermetic sealing in this manner, the second package 120 can suppress dust collection on the emission end faces of the light emitting chips 113 by organic substances or the like.

Some embodiments of the lens assembly 170 are introduced below with reference to the accompanying drawings.

The lens assembly 170 is usually composed of a plurality of integrally formed collimating lens units.

The lens assembly 170 includes an effective region and an ineffective region.

In some examples, a spacing between light emitting points of adjacent light emitting chips 113, as shown in FIG. 33, i.e., A, is 1.25 mm. Correspondingly, a center spacing of two adjacent collimating lens units is 1.25 mm, and an effective aperture of the lens is 3.4 mm. Then, a ratio of the center spacing of the lenses to the effective aperture of the lenses is 0.37.

In other embodiments provided in the present disclosure, the center spacing of two adjacent collimating lens units is 1 mm, the effective aperture of the lens remains unchanged, and the ratio of the center spacing of the lenses to the effective aperture of the lenses is 0.29.

Referring to FIG. 35, the lens assembly 170 is located above the light output path of the light transmitting component 160. The lens assembly 170 may be integrally formed from collimating lens units 171 having a lens shape and a rectangular base material portion 172 supporting the collimating lens units 171.

Centers of the plurality of collimating lens units 171 correspond to light output points on the reflection surfaces of the reflection components 150. Each collimating lens unit 171 collimates a beam emitted from the corresponding light emitting chip 113 and reflected by the reflection component 150.

Both the collimating lens units 171 and the base material portion 172 of the lens assembly 170 have light transmissivity. The lens assembly 170 can be formed using glass such as BK7, B270, or the like.

In some embodiments, the lens assembly 170 may be a cylindrical lens, used only to collimate a divergence angle of the laser beam in one direction.

In some embodiments, the lens assembly 170 has a light incident surface and a light exit surface, and at least one of the light incident surface and the light exit surface has a lens structure.

The lens assembly 170 has one or more lens surfaces. The one or more lens surfaces are provided on an upper surface side of the lens assembly 170. It should be noted that they may also be provided on a lower surface side of the lens assembly 170.

In some embodiments, the lens assembly 170 may be integrated with the light transmitting component 160.

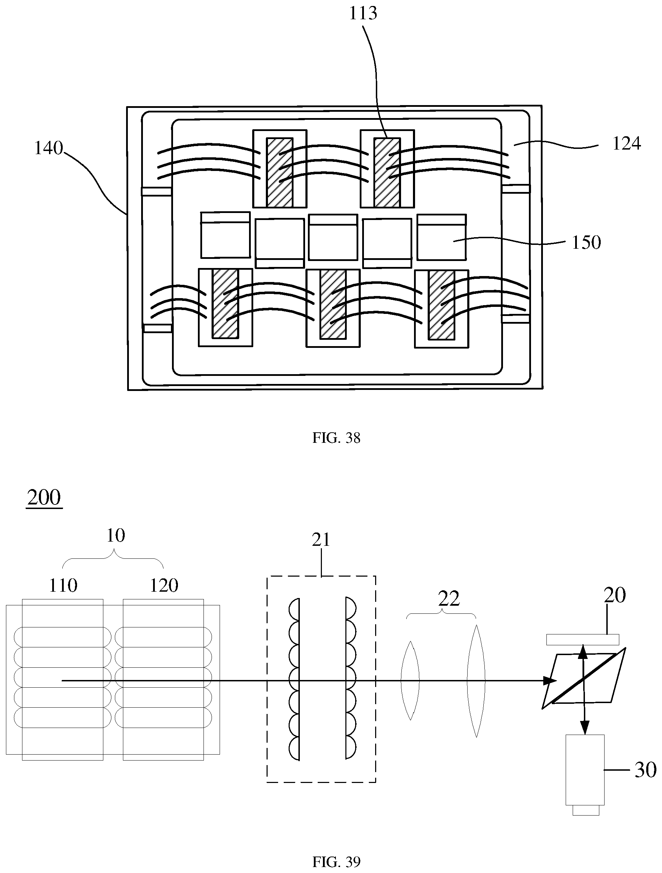

Furthermore, an embodiment of the present disclosure also provides a schematic diagram of an internal structure of a package. As shown in FIG. 38, a plurality of light emitting chips 113 are disposed inside the package and arranged in two rows. The numbers of light emitting chips in the two rows may be the same or different.

In a specific example, all of the light emitting chips 113 emit light of one color, for example, all emit red laser light. Furthermore, center wavelengths of the plurality of red light emitting chips may be set to be different. Specifically, when the number of light emitting chips is 5, 2 light emitting chips are arranged in a first row, and 3 light emitting chips are arranged in a second row. The light emitting chips in the first row and the second row are each connected in series and are connected to the conductive regions 124 of the sidewall 140 of the package via metal wires. The conductive regions 124 include pairs of connection pads, thereby connecting positive and negative electrodes of the light emitting chips.

In another specific implementation, the plurality of light emitting chips 113 include light emitting chips of different colors, for example, may include blue light emitting chips and green light emitting chips. Referring again to FIG. 38, in a specific implementation, a first row is provided with two blue light emitting chips, and all of the blue light emitting chips are connected in series and are respectively connected to the conductive regions 124 of the sidewall 140 of the package via metal wires. Furthermore, a second row is provided with three green light emitting chips, and all of the green light emitting chips are connected in series and are respectively connected to the conductive regions 124 of the sidewall 140 of the package via metal wires. The conductive regions 124 of the sidewall 140 of the package need to be provided with at least two sets of connection pads, respectively communicating with the blue light emitting chips and the green light emitting chips.

Furthermore, in some examples, the conductive regions 124 of the sidewall 140 of the package may have one positive electrode and two negative electrodes, so that the blue light emitting chips and the green light emitting chips share a common anode. Furthermore, in other examples, the conductive regions 124 of the sidewall 140 of the package may have one negative electrode and two positive electrodes, so that the blue light emitting chips and the green light emitting chips share a common cathode.

In the package structure exemplified in FIG. 38, by arranging the light emitting chips in two rows, a dimension in a length direction of the package can be reduced.

In addition, it should be noted that the laser device 10 described in the implementations of the present disclosure can be used in projectors, vehicle headlamps, head-mounted displays, lighting, displays, and the like.

Furthermore, an embodiment of the present disclosure also provides a laser apparatus, including a laser light source, an optical engine, and a lens, wherein the laser light source includes the above-described laser device 10.

The optical engine is used to receive the beam emitted from the laser device 10. The lens is disposed on the optical engine, and the lens performs imaging based on the beam processed by the optical engine.

The specific structure, working principle, and function of the laser device 10 have been described in detail in the foregoing embodiment 1, and are not repeated here.

It should be noted that the laser apparatus 200 includes the laser device 10, a light valve component 20, and a lens 30. The light valve component may be, for example, a DMD (Digital Micromirror Device) chip. Furthermore, the laser apparatus 200 also includes a main control circuit board, an audio processing system, speakers, and heat dissipation components.

The laser device 10 is used to emit a laser beam to the light valve component 20. Usually, the three-color laser beam emitted from the laser device 10 undergoes shaping processing before reaching the light valve component 20, such as passing through a homogenizing component 21 and a lens group 22, to be shaped to meet the incident size and angle requirements of the light valve component 20.

In the laser apparatus 200, the light valve component is connected to a display control chip in the main control circuit, and the main control circuit is also used to drive the laser device 10 to emit light.

In this example, the laser device 10 is driven to sequentially emit three-color laser beams, which are shaped by system optical components to form illumination beams, thereby being modulated by the light valve component 20. Driven by the display control chip, the light valve component 20 receives the three-primary-color illumination beams, and through reflection by thousands of tiny mirrors on the light valve surface, projects an image beam carrying image signals to the lens. The lens magnifies and images the image beam through a lens group.

In the laser apparatus 200 provided in this example, the laser device 10 emits three-color laser beams, so that the projected picture has higher brightness and better color gamut.

Furthermore, as shown in FIG. 39, since the laser device 10 encapsulates three-color lasers of high luminous power through two packages, it occupies less space during assembly of the optical path system, and corresponding heat dissipation components and drive control components can also be miniaturized correspondingly. Moreover, after the beam is emitted from the light source, the downstream optical path system also has conditions for miniaturization, which is beneficial for miniaturization of the entire laser apparatus.

It can be seen that the laser apparatus includes any of the above laser devices and has corresponding beneficial effects. To avoid repeated description, details are not repeated here.

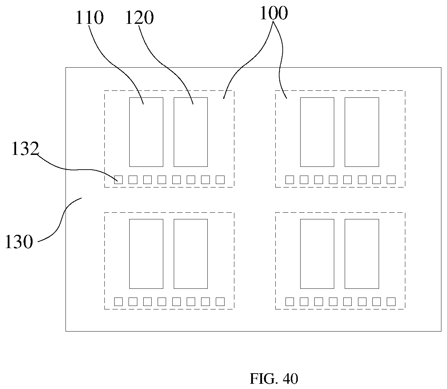

FIG. 40 is a schematic structural diagram of a laser device according to an embodiment of the present disclosure. Referring to FIG. 40, a plurality of light emitting units 100 are disposed on the mounting substrate 130 of the laser device. An internal structure of each light emitting unit 100 may be implemented with reference to the internal structure of any of the light emitting units described above. In one example, the plurality of light emitting units 100 on the mounting substrate 130 are arranged in an array (for example, two rows and two columns are shown in FIG. 40 as an example), and the internal structure of each light emitting unit 100 is exactly the same, and the mounting substrate 130 has exactly the same internal structure in a region corresponding to each light emitting unit 100; for example, each light emitting unit 100 may have a light emitting unit structure having a first package 110 and a second package 120 as shown in FIG. 5, FIG. 6, or FIG. 11, and the mounting substrate 130 is provided with a row of connection pads 132 at a position corresponding to each light emitting unit 100. In addition, although not shown in FIG. 40, the connection pattern of the mounting substrate 130 may include a conductive pattern corresponding to each light emitting unit 100, and each light emitting unit 100 is fixed on the corresponding conductive pattern and is electrically connected to the corresponding conductive pattern. In other examples, different light emitting units 100 on the same mounting substrate 130 may have different internal structures.

In the description of the present disclosure, it should be understood that terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., indicate orientations or positional relationships based on the orientations or positional relationships shown in the accompanying drawings. They are only for convenience of describing the present disclosure and simplifying the description, and do not indicate or imply that the referred device or element must have a specific orientation, be constructed and operated in a specific orientation, and therefore cannot be construed as limiting the present disclosure.

Furthermore, the terms "first" and "second" are used only for descriptive purposes and cannot be understood as indicating or implying relative importance or implicitly specifying the quantity of indicated technical features. Thus, features defined with "first" and "second" may explicitly or implicitly include at least one of the features. In the description of the present disclosure, "plurality" means at least two, such as two, three, etc., unless expressly and specifically defined otherwise.

A person of ordinary skill in the art can understand that all or part of the steps in the above embodiments can be implemented by hardware, or by instructing relevant hardware through a program. The program can be stored in a computer-readable storage medium. The above-mentioned storage medium may be a read-only memory, a magnetic disk, an optical disk, or the like.

The above description is only preferred embodiments of the present disclosure and is not intended to limit the present disclosure. Any modifications, equivalent substitutions, improvements, etc., made within the spirit and principles of the present disclosure shall be included within the protection scope of the present disclosure.

## Claims

1. A laser device, comprising:
a mounting substrate, comprising a connection pattern, a plurality of connection pads, and a plurality of intra-board connection lines, wherein at least four of the connection pads are electrically connected to the connection pattern via the plurality of intra-board connection lines; and
a light emitting unit, comprising at least one package and a plurality of light emitting chips disposed within the at least one package, wherein the at least one package is provided with a conductive structure on a side of the at least one package facing the mounting substrate, the connection pattern comprises a conductive pattern, the light emitting unit is fixed on the conductive pattern and is electrically connected to the conductive pattern, at least one sidewall connection line is disposed within a sidewall of the at least one package, and at least one of the light emitting chips is electrically connected to one of the sidewall connection lines within a sidewall of a package that houses the light emitting chip;
wherein the light emitting chips in the light emitting unit comprise chips having at least two different emission colors, the plurality of connection pads comprise a group of connection pads corresponding to each emission color of light emitting chips in the light emitting unit, each group of connection pads comprises two of the connection pads, and each group of connection pads is electrically connected to the light emitting chips having a corresponding color.

2. The laser device according to claim 1, wherein the light emitting unit further comprises a plurality of heat sinks corresponding to the plurality of light emitting chips, and each of the light emitting chips is mounted on the conductive pattern via a corresponding heat sink.

3. The laser device according to claim 2, wherein the conductive pattern comprises at least one conductive base corresponding to the at least one package in one-to-one correspondence, and each of the light emitting chips is mounted, via a corresponding heat sink, on a conductive base corresponding to a package that houses the light emitting chip.

4. The laser device according to claim 2, wherein the plurality of light emitting chips in each of the packages are arranged in at least one row, and a ratio of a length to a width of the heat sink is between 1 and 3.5.

5. The laser device according to claim 4, wherein the ratio of the length to the width of the heat sink is between 1.5 and 3.5; or the ratio of the length to the width of the heat sink is between 1 and 1.7.

6. The laser device according to claim 4 or 5, wherein a length H of the heat sink satisfies H = Ho*K1+K2, where Ho is a length of the light emitting chip, K1 is an accommodation coefficient, and K2 is a constant;
and/or,
a width L of the heat sink satisfies L ≥ (L0+2tanθ*D), where L0 is a width of the light emitting chip, D is a thickness of the heat sink, and θ is a heat conduction angle from the light emitting chip toward the heat sink.

7. The laser device according to claim 2, wherein a ratio of a width of the heat sink to a width of a package that houses the heat sink is between 0.05 and 0.2; and/or a ratio of a sum of widths of the heat sinks in each package to the width of the package is between 0.4 and 0.8.

8. The laser device according to claim 7, wherein the ratio of the width of the heat sink to the width of a package that houses the heat sink is between 0.07 and 0.12; and/or the ratio of the sum of widths of the heat sinks in each package to the width of the package is between 0.1 and 0.15.

9. The laser device according to claim 1, wherein light emitting chips, having the same color in the light emitting unit and being more than one in number, have at least two different center wavelengths, and a difference between any two of the at least two different center wavelengths is greater than or equal to 3 nm.

10. The laser device according to claim 9, wherein any two light emitting chips located within the same package have different center wavelengths.

11. The laser device according to claim 9, wherein light emitting chips, having the same color in a light emitting unit and being more than three in number, have three different center wavelengths, a difference between any two of the three different center wavelengths is greater than or equal to 3 nm, and a number of light emitting chips having a middle center wavelength in the light emitting unit is greater than a number of light emitting chips having a maximum center wavelength in the light emitting unit and a number of light emitting chips having a minimum center wavelength in the light emitting unit.

12. The laser device according to claim 9, wherein the light emitting unit comprises two packages, light emitting chips in one of the packages are arranged in a row in an order of increasing center wavelengths, and light emitting chips in the other package are arranged in a row in an order of decreasing center wavelengths along the same direction.

13. The laser device according to claim 1, wherein each of the light emitting chips has a plurality of light emitting points, and a ratio of a spacing between light emitting points of two adjacent light emitting chips in the same package to a width of the package is between 0.08 and 0.2; and/or
the light emitting unit further comprises a plurality of reflection components disposed within the at least one package, and a distance between two adjacent reflection components in the same package is between 0.35 mm and 0.45 mm.

14. The laser device according to claim 1, wherein orthographic projections of the plurality of connection pads on a plane where the mounting substrate is located at least partially overlap with orthographic projections of the plurality of intra-board connection lines on the plane, an orthographic projection of the connection pattern on the plane at least partially overlaps with the orthographic projections of the plurality of intra-board connection lines on the plane, and an orthographic projection of the conductive structure on the plane at least partially overlaps with the orthographic projection of the connection pattern on the plane; within the plane where the mounting substrate is located, the plurality of connection pads are located on the same side edge of the mounting substrate.

15. The laser device according to claim 14, wherein a length of each of the connection pads along an arrangement direction of the plurality of connection pads is between 1.3 mm and 1.7 mm; and a spacing between adjacent connection pads along the arrangement direction of the plurality of connection pads is between 0.8 mm and 1.2 mm.

16. The laser device according to any one of claims 1 to 15, wherein each of the light emitting chips is one of a first-type light emitting chip, a second-type light emitting chip, and a third-type light emitting chip, emission colors of which are different;
light emitting chips having the same color and located within the same package are connected in series and are respectively connected to two connection pads of a corresponding group of connection pads; and
wherein a number of connection pads corresponding to each of the packages is twice a number of color types of the light emitting chips in the package, two connection pads in each group of connection pads are a positive polarity pad and a negative polarity pad, respectively, and two connection pads in a group of connection pads connecting the light emitting chips which have the same color are adjacent to each other.

17. The laser device according to claim 16, wherein the conductive structure comprises a plurality of bottom pads, the conductive pattern comprises a plurality of transfer pads, the plurality of transfer pads are electrically connected to the plurality of bottom pads of the conductive structure in one-to-one correspondence, and at least one of the plurality of bottom pads is electrically connected to one of the sidewall connection lines within a sidewall of a package that houses the at least one bottom pad.

18. The laser device according to claim 16, wherein an emission wavelength of the third-type light emitting chips is longer than emission wavelengths of the first-type light emitting chips and the second-type light emitting chips; and
at least one of the light emitting units comprises a first package and a second package arranged side by side, each light emitting chip in the first package is the third-type light emitting chip, and each light emitting chip in the second package is one of the first-type light emitting chip and the second-type light emitting chip.

19. The laser device according to claim 18, wherein the light emitting unit further comprises a plurality of heat sinks in one-to-one correspondence with the plurality of light emitting chips, each of the light emitting chips is mounted on the conductive pattern via a corresponding heat sink, and each of the third-type light emitting chips is mounted on a side of a corresponding heat sink facing a group of connection pads corresponding to the third-type light emitting chips.

20. The laser device according to claim 18, wherein the light emitting unit further comprises a plurality of heat sinks in one-to-one correspondence with the plurality of light emitting chips, each of the light emitting chips is mounted on the conductive pattern via a corresponding heat sink, and Zener diodes are disposed on heat sinks corresponding to the first-type light emitting chips and on heat sinks corresponding to the second-type light emitting chips.

21. The laser device according to claim 16, wherein each of the light emitting units comprises a plurality of packages, light emitting chips in each of the packages have the same color, and an arrangement direction of the plurality of packages is the same as an arrangement direction of the plurality of connection pads.

22. The laser device according to claim 16, wherein a number of color types of the plurality of light emitting chips in the at least one package is three.

23. A laser apparatus, comprising the laser device according to any one of claims 1 to 22, a light valve assembly, and a lens.
